(19) Europäisches Patentamt
European Patent Office
Office européen des brevets

(11) **EP 4 060 692 A1**

(12) **EUROPEAN PATENT APPLICATION**

(43) Date of publication:
**21.09.2022 Bulletin 2022/38**

(21) Application number: **22161891.1**

(22) Date of filing: **14.03.2022**

(51) International Patent Classification (IPC):
***H01F 1/28*** *(2006.01)*   ***H01F 17/00*** *(2006.01)*
***H05K 1/02*** *(2006.01)*

(52) Cooperative Patent Classification (CPC):
**H01F 1/28; H01F 17/0013; H05K 1/0233**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.03.2021 JP 2021042919**

(71) Applicant: **AJINOMOTO CO., INC.**
**Chuo-ku**
**Tokyo 104-8315 (JP)**

(72) Inventors:
• **OURA, Ichiro**
**Kanagawa (JP)**
• **SAITO, Mizuki**
**Kanagawa (JP)**
• **OOYAMA, Hideki**
**Kanagawa (JP)**

(74) Representative: **Mewburn Ellis LLP**
**Aurora Building**
**Counterslip**
**Bristol BS1 6BX (GB)**

(54) **RESIN COMPOSITION**

(57)    A resin composition comprising: (A) an alloy magnetic powder having a BET specific surface area $S_A$ of 2 m$^2$/g or more and 10 m$^2$/g or less; (B) a magnetic powder having a BET specific surface area $S_B$ of 0.1 m$^2$/g or more and less than 2 m$^2$/g; and (C) a binder resin.

# FIG.8

EP 4 060 692 A1

**Description**

BACKGROUND OF THE INVENTION

Field of the Invention

The present invention relates to a resin composition including a magnetic powder.

Description of the Related Art

An inductor element is provided in many information terminals such as a cell phone and a smart phone. In recent years, a method of installing an inductor element inside a substrate by forming a coil with the substrate's conductor pattern may be used. A known method of forming these inductor elements is to use a resin composition including a magnetic powder. Known examples of the resin composition include a pasty resin composition for filling a hole such as a through-hole and a film-shaped resin compositions for forming a magnetic layer (Patent Literatures 1 and 2).
In recent years, it is required to further improve magnetic properties of a magnetic material in order to further enhance the performance of the inductor element. One possible method of improving the magnetic properties of the magnetic material is to increase the content of the magnetic powder in the material. For example, there is a known technology that uses two or more types of magnetic metal powders having different average particle diameters to improve the filling rate of the powder thereby enhancing the magnetic properties (Patent Literature 3).

Related Art Reference

Patent Literature

Patent Literature 1: International Publication No. 2019/181463
Patent Literature 2: Japanese Patent Application Laid-open No. 2015-187260
Patent Literature 3: Japanese Patent Application Laid-open No. 2019-220609

SUMMARY OF THE INVENTION

Problem to be Solved by the Invention

In conventional resin compositions, the thixotropy of the resin composition tends to increase as the filling rate of the magnetic powder is increased. When the thixotropy of the resin composition is high, the filling property may be inferior in hole-filling application where holes such as a through-hole are filled by the pasty resin composition. Also, when the thixotropy of the resin composition is high, the filling property around a wiring pattern may be inferior in the application where a magnetic layer is formed by a film-shaped resin composition.
The present invention was conceived in consideration of the above-mentioned problems; and thus, the object of the present invention is to provide a resin composition that has a low thixotropy and an excellent filling property, and also can give a cured product having a high relative permeability.

Means for Solving the Problem

The inventors of the present invention carried out an extensive investigation to solve the problems described above. As a result, the inventors found that a resin composition including a combination of an alloy magnetic powder having a BET specific surface area in a specific range, a magnetic powder having a BET specific surface area in another specific range, and a binder resin can solve the above-mentioned problems. Based on the finding mentioned above, the present invention has been achieved.
Namely, the present invention includes the following aspects.

[1] A resin composition comprising:

(A) an alloy magnetic powder having a BET specific surface area $S_A$ of 2 m$^2$/g or more and 10 m$^2$/g or less;
(B) a magnetic powder having a BET specific surface area $S_B$ of 0.1 m$^2$/g or more and less than 2 m$^2$/g; and
(C) a binder resin.

[2] The resin composition according to [1], wherein a volume ratio of the (A) component and the (B) component ((B) component/(A) component) is 0.9 or more and 20.0 or less.

[3] The resin composition according to [1] or [2], wherein a total amount of the (A) component and the (B) component relative to 100% by volume of nonvolatile components in the resin composition is 50% or more by volume.

[4] The resin composition according to any one of [1] to [3], wherein the (A) component comprises an iron alloy type powder comprising Fe, Si, and Cr.

[5] The resin composition according to any one of [1] to [4], wherein the (C) component comprises a thermosetting resin.

[6] The resin composition according to any one of [1] to [5], wherein the (C) component comprises an epoxy resin.

[7] The resin composition according to [6], further comprising (D) an epoxy curing facilitator.

[8] The resin composition according to any one of [1] to [7], wherein a amount of the (C) component relative to 100% by mass of resin components in the resin composition is 60% or more by mass.

[9] The resin composition according to any one of [1] to [8], wherein the resin composition is in a pasty form at 23°C.

[10] A cured product of the resin composition according to any one of [1] to [9].

[11] A resin sheet comprising:

a support; and
a resin composition layer formed of the resin composition according to any one of [1] to [9], the resin composition layer being formed on the support.

[12] A circuit substrate comprising a cured product of the resin composition according to any one of [1] to [9] .

[13] A circuit substrate comprising:

a substrate formed with a through-hole; and
a cured product of the resin composition according to any one of [1] to [9], the cured product being filled in the through-hole.

[14] An inductor substrate comprising the circuit substrate according to [12] or [13].

Advantageous Effects of Invention

According to the present invention, a resin composition can be provided that has a low thixotropy and an excellent filling property, and can give a cured product having a high relative magnetic permeability.

BRIEF DESCRIPTION OF THE DRAWINGS

Fig. 1 is a schematic sectional view illustrating the core substrate that is prepared in the production method of the circuit substrate according to the first example of one embodiment of the present invention;
Fig. 2 is a schematic sectional view illustrating the core substrate formed with a through-hole in the production method of the circuit substrate according to the first example of one embodiment of the present invention;
Fig. 3 is a schematic sectional view illustrating the core substrate formed with a plated layer in the through-hole in the production method of the circuit substrate according to the first example of one embodiment of the present invention;
Fig. 4 is a schematic sectional view illustrating the state of the resin composition filled in the through-hole of the core substrate in the production method of the circuit substrate according to the first example of one embodiment of the present invention;
Fig. 5 is a schematic sectional view to explain the step (2) in the production method of the circuit substrate according to the first example of one embodiment of the present invention;
Fig. 6 is a schematic sectional view to explain the step (3) in the production method of the circuit substrate according to the first example of one embodiment of the present invention;
Fig. 7 is a schematic sectional view to explain the step (5) in the production method of the circuit substrate according to the first example of one embodiment of the present invention;
Fig. 8 is a schematic sectional view to explain the step (5) in the production method of the circuit substrate according to the first example of one embodiment of the present invention;
Fig. 9 is a schematic sectional view to explain the step (i) in the production method of the circuit substrate according to the second example of one embodiment of the present invention;

Fig. 10 is a schematic sectional view to explain the step (i) in the production method of the circuit substrate according to the second example of one embodiment of the present invention;

Fig. 11 is a schematic sectional view to explain the step (ii) in the production method of the circuit substrate according to the second example of one embodiment of the present invention;

Fig. 12 is a schematic sectional view to explain the step (iv) in the production method of the circuit substrate according to the second example of one embodiment of the present invention;

Fig. 13 is a schematic plane view of the circuit substrate possessed by the inductor substrate, observed from one side in the thickness direction thereof;

Fig. 14 is a schematic view illustrating a cut edge face of the circuit substrate that is cut at the place indicated by the II-II one dot chain line illustrated in Fig. 13; and

Fig. 15 is a schematic plane view to explain the composition of the first conductive layer of the circuit substrate included in the inductor substrate.

DETAILED DESCRIPTION OF THE PREFERRED EMBODIMENTS

Hereinafter, the present invention will be explained in detail in line with the preferable embodiments thereof. Here, the present invention is not limited to the embodiments and examples described below, and the present invention may be carried out with any arbitrary modification so far as such modification is not outside the claims or the equivalent thereof in the present invention.

In the explanation described hereinafter, " magnetic permeability" means "relative magnetic permeability" unless otherwise specifically mentioned.

[1. Outline of the Resin Composition]

The resin composition according to one embodiment of the present invention includes a combination of (A) an alloy magnetic powder having a BET specific surface area $S_A$ of 2 m$^2$/g or more and 10 m$^2$/g or less, (B) a magnetic powder having a BET specific surface area $S_B$ of 0.1 m$^2$/g or more and less than 2 m$^2$/g, and (C) a binder resin.

This resin composition can have a low thixotropy and an excellent filling property. According to this resin composition, a cured product having a high relative magnetic permeability can be obtained. With regard to the mechanism how the resin composition can have such excellent effects, the inventors of the present invention presume as follows. However, the technological scope of the present invention is not restricted by the mechanism described below.

In the above-mentioned resin composition, the particle diameter of the (A) component is usually small, and the particle diameter of the (B) component is large. Therefore, in the resin composition, the particles of the

(A) component can enter the gap formed between the particles of the (B) component. As a result, the (A) and (B) components can be densely dispersed in the resin composition as a whole, so that the cured product obtained by curing the resin composition can have a high relative magnetic permeability.

In general, because a smaller particle has a larger specific surface area, the friction on the surface of this particle tends to be larger, and thus the thixotropy tends to be larger. For example, a nano ferrite powder tends to have a large specific surface area while having a small particle diameter. However, the (A) component formed by an alloy can have a small specific surface area for the particle diameter, so that the friction on the particle surface thereof can be reduced. Therefore, the thixotropy of the resin composition can be lowered, so that an excellent filling property can be obtained.

The resin composition may further include an optional component in combination with the (A) component, the (B) component, and the (C) component. Here, it is preferable that the amount of an optional magnetic powder other than the (A) and (B) components included in the resin composition be small, and it is more preferable that the resin composition do not include the optional magnetic powder other than the (A) and (B) components. Specifically, the amount of the optional magnetic powder in the resin composition is preferably 0% to 10% by mass, more preferably 0% to 5% by mass, and especially preferably 0% to 1% by mass, while ideally 0% by mass.

[2. (A) Alloy Magnetic Powder]

The resin composition according to one embodiment of the present invention includes, as the (A) component, (A) an alloy magnetic powder having a BET specific surface area $S_A$ in a specific range. The (A) alloy magnetic powder may be a soft magnetic powder or a hard magnetic powder. Among them, it is preferable that the (A) alloy magnetic powder be a soft magnetic powder from the viewpoint to effectively obtain the effects of the present invention.

Examples of the (A) magnetic alloy powder may include crystaline or non-crystalline alloy powders such as a Fe-Si type alloy powder, a Fe-Si-Al type alloy powder, a Fe-Cr type alloy powder, a Fe-Si-Cr type alloy powder, a Fe-Ni-Cr type alloy powder, a Fe-Cr-Al type alloy powder, a Fe-Ni type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. Among them, the iron alloy type powder is preferable as the (A) alloy magnetic powder. As for the iron alloy type powder, the iron alloy type powder containing Fe, as well as at least one element selected from the group consisting of Si, Cr, Al, Ni, and Co is preferable. Furthermore, the iron alloy type powder containing Fe, as well as at least one element selected from the group consisting of Si, Cr, and Ni is preferable. It is especially preferable that the (A) alloy magnetic powder include at least one alloy type powder selected from the group consisting of a Fe-Si-Cr type alloy powder and a Fe-Ni type alloy powder. The Fe-Si-Cr type alloy powder represents the alloy powder including Fe, Si, and Cr; and the Fe-Ni type alloy powder represents the alloy powder including Fe and Ni.

The (A) alloy magnetic powder may include only one type of powder, or two or more types of powders.

The BET specific surface area $S_A$ of the (A) alloy magnetic powder is usually 2.0 $m^2/g$ or more, preferably 2.5 $m^2/g$ or more, more preferably more than 2.5$m^2/g$, and still more preferably 2.6$m^2/g$ or more, while especially preferably 3.0 $m^2/g$ or more, and is preferably 10 $m^2/g$ or less, and more preferably 9.5 $m^2/g$ or less, while still more preferably 9 $m^2/g$ or less. When the (A) alloy magnetic powder has a BET specific surface area $S_A$ in the above-mentioned range, the relative magnetic permeability of the cured product, as well as the thixotropy and filling property of the resin composition can be excellent.

It is preferable that the BET specific surface area $S_A$ of the (A) alloy magnetic powder satisfy a specific relationship with the BET specific surface area $S_B$ of the (B) magnetic powder.

Specifically, the ratio $S_A/S_B$, the ratio of the BET specific surface area $S_A$ of the (A) alloy magnetic powder to the BET specific surface area $S_B$ of the (B) magnetic powder is preferably 2.0 or more, and more preferably 5.0 or more, while especially preferably 8.0 or more, and is preferably 50 or less, and more preferably 25 or less, while especially preferably 20 or less. When the ratio $S_A/S_B$ is within the above-mentioned range, the relative magnetic permeability of the cured product, as well as the thixotropy and filling property of the resin composition can be especially excellent.

The difference $S_A$-$S_B$ between the BET specific surface area $S_A$ of the (A) alloy magnetic powder and the BET specific surface area $S_B$ of the (B) magnetic powder, is preferably 2.0 $m^2/g$ or more, and more preferably 4.0 $m^2/g$ or more, while especially preferably 5.0 $m^2/g$ or more, and is preferably 9.0 $m^2/g$ or less, and more preferably 8.7 $m^2/g$ or less, while especially preferably 8.5 $m^2/g$ or less. When the difference $S_A$-$S_B$ is in the above-mentioned range, the relative magnetic permeability of the cured product, as well as the thixotropy and filling property of the resin composition can be especially excellent.

Furthermore, the weighted average of the BET specific surface area $S_A$ of the (A) alloy magnetic powder and the BET specific surface area $S_B$ of the (B) magnetic powder on a volume basis is preferably in a specific range. Specifically, the weighted average on a volume basis is preferably 1.0 $m^2/g$ or more, and more preferably 1.5 $m^2/g$ or more, while especially preferably 2.0 $m^2/g$ or more, and is preferably 6.0 $m^2/g$ or less, and more preferably 4.5 $m^2/g$ or less, while especially preferably 3.5 $m^2/g$ or less. The weighted average on a volume basis described above represents the value obtained by summing the product of the BET specific surface area $S_A$ of the (A) alloy magnetic powder and its volume ratio and the product of the BET specific surface area $S_B$ of the (B) magnetic powder and its volume ratio. The above-mentioned volume ratio represents the ratio relative to 100% by volume as the total of the (A) alloy magnetic powder and the (B) magnetic powder. When the weighted average is within the above-mentioned range, the relative magnetic permeability of the cured product, as well as the thixotropy and filling property of the resin composition can be especially excellent.

The weighted average of the BET specific surface area $S_A$ of the (A) alloy magnetic powder and the BET specific surface area $S_B$ of the (B) magnetic powder on a mass basis is preferably in a specific range. Specifically, the weighted average on a mass basis is preferably 1.0 $m^2/g$ or more, and more preferably 1.5 $m^2/g$ or more, while especially preferably 2.0 $m^2/g$ or more, and is preferably 6.0 $m^2/g$ or less, and more preferably 4.5 $m^2/g$ or less, while especially preferably 3.5 $m^2/g$ or less. The weighted average on a mass basis described above represents the value obtained by summing the product of the BET specific surface area $S_A$ of the (A) alloy magnetic powder and its mass ratio and the product of the BET specific surface area $S_B$ of the (B) magnetic powder and its mass ratio. The above-mentioned mass ratio represents the ratio relative to 100% by mass as the total of the (A) alloy magnetic powder and the (B) magnetic powder. When the weighted average is within the above-mentioned range, the relative magnetic permeability of the cured product, as well as the thixotropy and filling property of the resin composition can be especially excellent. Normally, the BET specific surface area of the entire magnetic powders, including the (A) alloy magnetic powder, the (B) magnetic powder, and an optional magnetic powder included in the resin composition, can fall within the range of the weighted average on a mass basis described above.

The BET specific surface area can be measured by the BET method. Specifically, the BET specific surface area can be measured according to the BET method by adsorbing a nitrogen gas onto the sample surface using a specific surface area measurement instrument ("Macsorb HM Model 1210" manufactured by Mountech Co., Ltd.) and using the BET multipoint method.

It is preferable that the (A) alloy magnetic powder be a substantially spherical particle or a substantially ellipsoidal particle. The aspect ratio of the particle of the (A) alloy magnetic powder is preferably 2 or less, more preferably 1.5 or less, and still more preferably 1.2 or less, and is usually 1.0 or more. The aspect ratio described above represents the ratio (Lb/La) of the major axis (Lb) to the minor axis (La).

The average particle diameter of the (A) alloy magnetic powder is preferably 0.8 $\mu$m or less, more preferably 0.6 $\mu$m or less, still more preferably 0.4 $\mu$m or less, and still more preferably 0.3 $\mu$m or less, while especially preferably 0.2 $\mu$m or less. The lower limit of the average particle diameter of the (A) alloy magnetic powder may be, although not particularly restricted, preferably 0.01 $\mu$m or more, more preferably 0.05 $\mu$m or more, and still more preferably 0.1 $\mu$m or more, while especially preferably 0.12 $\mu$m or more.

The average particle diameter represents the median diameter on a volume basis, unless otherwise specifically mentioned. The average particle diameter can be measured with a laser diffraction scattering method based on the Mie scattering theory. Specifically, the particle diameter distribution thereof is prepared on a volume basis by using a laser diffraction scattering type particle diameter distribution measurement instrument, in which the median diameter thereof can be measured as the average particle diameter. The powders that are dispersed in water by means of an ultrasonic wave can be suitably used as the measurement sample. Illustrative examples of the laser diffraction scattering type particle diameter distribution measurement instrument may include "LA-960" manufactured by Horiba Ltd. and "SALD-2200" manufactured by Shimadzu Corp.

The true specific gravity of the (A) alloy magnetic powder may be, for example, 6.5 g/cm$^3$ to 9.0 g/cm$^3$.

The (A) alloy magnetic powders that are commercially available may be used. Specific examples of the (A) alloy magnetic powder that is commercially available may include "G00129D", "G00212D", and "G00220DC", manufactured by JFE Mineral Co., Ltd. These may be used singly or as a combination of two or more of them.

The amount (% by volume) of the (A) alloy magnetic powder included in the resin composition relative to 100% by volume of the nonvolatile components in the resin composition is preferably 1.0% or more by volume, and more preferably 5.0% or more by volume, while especially preferably 10% or more by volume, and is preferably 50% or less by volume, and more preferably 40% or less by volume, while especially preferably 30% or less by volume. When the amount of the (A) alloy magnetic powder is within the above-mentioned range, the relative magnetic permeability of the cured product, as well as the thixotropy and filling property of the resin composition can be especially excellent. The volume of each component included in the resin composition can be obtained by dividing the mass thereof by the true specific gravity.

The amount (% by mass) of the (A) alloy magnetic powder included in the resin composition relative to 100% by mass of the nonvolatile components in the resin composition is preferably 1.0% or more by mass, and more preferably 5.0% or more by mass, while especially preferably 10% or more by mass, and is preferably 70% or less by mass, and more preferably 50% or less by mass, while especially preferably 40% or less by mass. When the amount of the (A) alloy magnetic powder is within the above-mentioned range, the relative magnetic permeability of the cured product, as well as the thixotropy and filling property of the resin composition can be especially excellent.

The amount of the (A) alloy magnetic powder is set preferably such that the volume ratio ((B) component/(A) component) of the (A) alloy magnetic powder and the (B) magnetic powder falls within a specific range. Specifically, the volume ratio ((B) component/(A) component) of the (A) alloy magnetic powder and the (B) magnetic powder is preferably 0.9 or more, more preferably 1.0 or more, and still more preferably 1.3 or more, while especially preferably 1.9 or more, and is preferably 20.0 or less, more preferably 19.0 or less, and still more preferably 15.0 or less, while especially preferably 10.0 or less. The volume of each component included in the resin composition, such as the (A) alloy magnetic powder and the (B) magnetic powder, can be obtained by dividing the mass thereof by the true specific gravity. The above-mentioned volume ratio ((B) component/(A) component) can be obtained by dividing the volume of the (B) magnetic powder thus obtained by the volume of the (A) alloy magnetic powder. When the volume ratio ((B) component/(A) component) is within the above-mentioned range, the relative magnetic permeability of the cured product, as well as the thixotropy and filling property of the resin composition can be especially excellent.

It is preferable that the amount of the (A) alloy magnetic powder be set such that the total amount of the (A) alloy magnetic powder and the (B) magnetic powder falls within a specific range. Specifically, the total amount (% by volume) of the (A) alloy magnetic powder and the (B) magnetic powder relative to 100% by volume of the nonvolatile components in the resin composition is preferably 50% or more by volume, and more preferably 55% or more by volume, while especially preferably 60% or more by volume, and is preferably 80% or less by volume, and more preferably 76% or less by volume, while especially preferably 73% or less by volume. When the total amount of the (A) alloy magnetic powder and the (B) magnetic powder is within the above-mentioned range, the relative magnetic permeability of the cured product, as well as the thixotropy and filling property of the resin composition can be especially excellent.

The total amount (% by mass) of the (A) alloy magnetic powder and the (B) magnetic powder relative to 100% by mass of the nonvolatile components in the resin composition is preferably 80% or more by mass, and more preferably 85% or more by mass, while especially preferably 90% or more by mass, and is preferably 99% or less by mass, and more preferably 96% or less by mass, while especially preferably 94% or less by mass. When the total amount of the (A) alloy magnetic powder and the (B) magnetic powder is within the above-mentioned range, the relative magnetic permeability of the cured product, as well as the thixotropy and filling property of the resin composition can be especially excellent.

It is preferable that the amount of the (A) alloy magnetic powder be set such that the mass ratio ((A) component/(C) component) of the (A) alloy magnetic powder and the (C) binder resin falls within a specific range. Specifically, the mass ratio ((A) component/(C) component) of the (A) alloy magnetic powder and the (C) binder resin is preferably 0.5 or more, and more preferably 1.0 or more, while especially preferably 2.0 or more, and is preferably 20 or less, and more preferably 10 or less, while especially preferably 6.0 or less. When the mass ratio ((A) component/(C) component) of the (A) alloy magnetic powder and the (C) binder resin is within the above-mentioned range, the relative magnetic permeability of the cured product, as well as the thixotropy and filling property of the resin composition can be especially excellent.

It is preferable that the amount of the (A) alloy magnetic powder be set such that the volume ratio ((A) component/(C) component) of the (A) alloy magnetic powder and the (C) binder resin falls within a specific range. Specifically, the volume ratio ((A) component/(C) component) of the (A) alloy magnetic powder and the (C) binder resin is preferably 0.05 or more, and more preferably 0.10 or more, while especially preferably 0.40 or more, and is preferably 1.5 or less, and more preferably 1.0 or less, while especially preferably 0.80 or less. When the volume ratio ((A) component/(C) component) of the (A) alloy magnetic powder and the (C) binder resin is within the above-mentioned range, the relative magnetic permeability of the cured product, as well as the thixotropy and filling property of the resin composition can be especially excellent.

[3. (B) Magnetic Powder]

The resin composition according to one embodiment of the present invention includes, as the (B) component, the (B) magnetic powder having a BET specific surface area $S_B$ in a specific range. The type of the (B) magnetic powder is not particularly restricted. Therefore, the (B) magnetic powder may be any of a soft magnetic powder and a hard magnetic powder. In particular, from the viewpoint to effectively obtain the effects of the present invention, the (B) magnetic powder is preferably a soft magnetic powder. Illustrative examples of the (B) magnetic powder may include a magnetic metal oxide powder and a magnetic metal powder.

Illustrative examples of the magnetic metal oxide powder may include ferrite powders such as a Fe-Mn type ferrite powder, a Mg-Zn type ferrite powder, a Mn type ferrite powder, a Mn-Zn type ferrite powder, a Mn-Mg type ferrite powder, a Cu-Zn type ferrite powder, a Mg-Sr type ferrite powder, a Mn-Mg-Sr type ferrite powder, a Ni-Zn type ferrite powder, a Ni-Zn-Cu type ferrite powder, a Ba-Zn type ferrite powder, a Ba-Mg type ferrite powder, a Ba-Ni type ferrite powder, a Ba-Co type ferrite powder, a Ba-Ni-Co type ferrite powder, and a Y type ferrite powder; and iron oxide powders such as an iron oxide powder (III) and a tri-iron tetroxide powder.

Illustrative examples of the magnetic metal powder may include a pure iron powder; and crystalline or non-crystalline alloy magnetic powders such as a Fe-Si type alloy powder, a Fe-Si-Al type alloy powder, a Fe-Cr type alloy powder, a Fe-Si-Cr type alloy powder, a Fe-Ni-Cr type alloy powder, a Fe-Cr-Al type alloy powder, a Fe-Ni type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder.

The (B) magnetic powder includes preferably at least one magnetic powder selected from the ferrite powders and the alloy magnetic powders. From the viewpoint to further improve the magnetic permeability, it is preferable that the (B) magnetic powder include one or more alloy magnetic powders. As for the alloy magnetic powder, the iron alloy type powder is preferable. As for the iron alloy type powder, the iron alloy type powder containing Fe, as well as at least one element selected from the group consisting of Si, Cr, Al, Ni, and Co is preferable. More preferable is the iron alloy type powder containing Fe, as well as at least one element selected from the group consisting of Si, Cr, and Ni. It is especially preferable that the (B) magnetic powder include at least one alloy magnetic powder selected from a Fe-Si-Cr type alloy powder and a Fe-Ni type alloy powder.

The (B) magnetic powder may include only one type of the powder or two or more types of the powders.

The BET specific surface area $S_B$ of the (B) magnetic powder is usually 0.1 $m^2/g$ or more, preferably 0.2 $m^2/g$ or more, and more preferably 0.3 $m^2/g$ or more, and is usually less than 2.0 $m^2/g$, and more preferably 1.5 $m^2/g$ or less, while still more preferably 1.0 $m^2/g$ or less. When the (B) magnetic powder has the BET specific surface area $S_B$ within the above-mentioned range, the relative magnetic permeability of the cured product, as well as the thixotropy and filling property of the resin composition can be excellent.

It is preferable that the (B) magnetic powder is a substantially spherical particle or a substantially ellipsoidal particle. The aspect ratio of the particle of the (B) magnetic powder is preferably 4 or less, and more preferably 3 or less, while still more preferably 2 or less, and is usually 1.0 or more.

The average particle diameter of the (B) magnetic powder is preferably 1.5 μm or more, more preferably 2.0 μm or more, still more preferably 2.5 μm or more, and still more preferably 2.7 μm or more, while especially preferably

2.8 μm or more, and is preferably 50.0 μm or less, more preferably 40.0 μm or less, and still more preferably 30.0 μm or less, while especially preferably 25.0 μm or less.

The true specific gravity of the (B) magnetic powder may be, for example, 4.0 g/cm$^3$ to 10 g/cm$^3$.

The (B) magnetic powders that are commercially available may be used. Specific examples of the commercially available product of the (B) magnetic powder may include: "AW02-08PF03", "KUAMET 6B2-53um", and "KUAMET NC1-53um", which are all manufactured by Epson Atmix Corp.; "Fe-50Ni" manufactured by DOWA Electronics Material Co., Ltd.; and "MZ05S", "MZ10S", and "M05S", which are all manufactured by Powdertech Co., Ltd. These may be used singly or as a combination of two or more of them.

The amount (% by volume) of the (B) magnetic powder included in the resin composition relative to 100% by volume of the nonvolatile components in the resin composition is preferably 10% or more by volume, and more preferably 20% or more by volume, while especially preferably 30% or more by volume, and is preferably 80% or less by volume, and more preferably 70% or less by volume, while especially preferably 60% or less by volume. When the amount of the (B) magnetic powder is within the above-mentioned range, the relative magnetic permeability of the cured product, as well as the thixotropy and filling property of the resin composition can be especially excellent.

The amount (% by mass) of the (B) magnetic powder included in the resin composition relative to 100% by mass of the nonvolatile components in the resin composition is preferably 20% or more by mass, and more preferably 30% or more by mass, while especially preferably 50% or more by mass, and is preferably 90% or less by mass, and more preferably 80% or less by mass, while especially preferably 70% or less by mass. When the amount of the (B) magnetic powder is within the above-mentioned range, the relative magnetic permeability of the cured product, as well as the thixotropy and filling property of the resin composition can be especially excellent.

[4. (C) Binder Resin]

The resin composition according to one embodiment of the present invention includes (C) a binder resin as the (C) component. For example, a thermosetting resin and a thermoplastic resin can be used as the binder resin. Illustrative examples of the thermosetting resin may include an epoxy resin, a phenol type resin, a naphthol type resin, a benzoxazine type resin, an active ester type resin, a cyanate ester type resin, a carbodiimide type resin, an amine type resin, and an acid anhydride type resin. Illustrative examples of the thermoplastic resin may include a phenoxy resin, an acrylic resin, a polyvinyl acetal resin, a butyral resin, a polyimide resin, a polyamide-imide resin, a polyether sulfone resin, and a polysulfone resin. The (C) binder resin may be used singly or as a combination of two or more of these resins. Therefore, for example, a combination of a thermosetting resin and a thermoplastic resin may be used as the (C) binder resin. In particular, it is preferable to use a thermosetting resin as the (C) binder resin.

The epoxy resin is preferable as the thermosetting resin. The "epoxy resin" means the resin having an epoxy group. When the (C) binder resin includes the epoxy resin, the relative magnetic permeability of the cured product, as well as the thixotropy and filling property of the resin composition can be especially excellent.

Illustrative examples of the epoxy resin may include a bixylenol type epoxy resin, a bisphenol A type epoxy resin, a bisphenol F type epoxy resin, a bisphenol S type epoxy resin, a bisphenol AF type epoxy resin, a dicyclopentadiene type epoxy resin, a trisphenol type epoxy resin, a naphthol novolak type epoxy resin, a phenol novolak type epoxy resin, a tert-butyl-catechol type epoxy resin, a naphthalene type epoxy resin, a naphthol type epoxy resin, an anthracene type epoxy resin, a glycidylamine type epoxy resin, a glycidyl ester type epoxy resin, a cresol novolak type epoxy resin, a biphenyl type epoxy resin, a linear aliphatic type epoxy resin, an epoxy resin having a butadiene structure, an alicyclic epoxy resin, a heterocyclic epoxy resin, an epoxy resin including a spiro ring, a cyclohexane type epoxy resin, a cyclohexane-dimethanol type epoxy resin, a naphthylene ether type epoxy resin, a trimethylol type epoxy resin, a tetraphenylethane type epoxy resin, a glycidyl ether type aliphatic epoxy resin, and a glycidyl ether type aromatic epoxy resin. The epoxy resin may be used singly or as a combination of two or more of these epoxy resins.

It is preferable that the resin composition include, as the epoxy resin, the epoxy resin having two or more epoxy groups in one molecule thereof. From the viewpoint to effectively obtain the intended effects of the present invention, the rate of the epoxy resin having two or more epoxy groups in one molecule relative to 100% by mass of the nonvolatile components in the (B) epoxy resin is preferably 50% or more by mass, and more preferably 60% or more by mass, while especially preferably 70% or more by mass.

It is preferable that the epoxy resin have an aromatic structure. When two or more epoxy resins are used, it is preferable that one or more of the epoxy resins have an aromatic structure. The aromatic structure is the chemical structure that is generally defined as aromatic, including a polycyclic aromatic ring and an aromatic heterocycle.

In the epoxy resin, there are an epoxy resin that is in the state of liquid at 25°C (hereinafter, this may be called "liquid epoxy resin") and an epoxy resin that is in the state of solid at 25°C (hereinafter, this may be called "solid epoxy resin"). Although the resin composition may include, as the epoxy resin, only the liquid epoxy resin, or may be a combination of the solid epoxy resin in addition to the liquid epoxy resin, in a preferable embodiment only the liquid epoxy resin is included.

The amount of the liquid epoxy resin relative to 100% by mass of the entire epoxy resin is preferably 60% or more by mass, more preferably 80% or more by mass, and still more preferably 90% or more by mass, while especially preferably 100% by mass.

It is preferable that the liquid epoxy resin be the liquid epoxy resin that has two or more epoxy groups in one molecule thereof.

The liquid epoxy resin is preferably a glycyrol type epoxy resin, a bisphenol A type epoxy resin, a bisphenol F type epoxy resin, a bisphenol AF type epoxy resin, a naphthalene type epoxy resin, a glycidyl type ether aliphatic epoxy resin, a glycidyl ether type aromatic epoxy resin, a glycidyl ester type epoxy resin, a glycidyl amine type epoxy resin, a phenol novolak type epoxy resin, an alicyclic epoxy resin having an ester skeleton, a cyclohexane dimethanol type epoxy resin, a dicyclopentadiene type epoxy resin, or an epoxy resin having a butadiene structure. Among these, a bisphenol A type epoxy resin, a bisphenol F type epoxy resin, a glycidyl ether type aliphatic epoxy resin, and a glycidyl ether type aromatic epoxy resin are more preferable.

Specific examples of the liquid epoxy resin may include "HP4032", "HP4032D", and "HP4032SS" (naphthalene type epoxy resins), which are all manufactured by DIC Corp.; "828US" and "jER828EL" (bisphenol A type epoxy resins), "jER807" (a bisphenol F type epoxy resin), and "jER152" (a phenol novolak type epoxy resin), which are all manufactured by Mitsubishi Chemical Corp.; "630" and "630LSD" (glycidyl ether type aromatic epoxy resins), which are both manufactured by Mitsubishi Chemical Corp.; "ED-523T" (a glycyrol type epoxy resin (ADEKA glycyrol)), "EP-3980S" (a glycidyl amine type epoxy resin), and "EP-4088S" (a glycidyl ether type aliphatic epoxy resin), which are all manufactured by ADEKA Corp.; "ZX-1059" (a mixture of a bisphenol A type epoxy resin and a bisphenol F type epoxy resin) manufactured by Nippon Steel Chemical & Materials Co., Ltd.; "EX-721" (a glycidyl ester type epoxy resin) manufactured by Nagase ChemteX Corp.; "Celloxide 2021P" (an alicyclic epoxy resin having an ester skeleton) and "PB-3600" (an epoxy resin having a butadiene skeleton), which are manufactured by Daicel Corp.; and "ZX1658" and "ZX1658GS" (liquid 1,4-glycidylcyclohexanes), which are manufactured by Nippon Steel Chemical & Materials Co., Ltd.

As for the solid epoxy resin, the solid epoxy resin having three or more epoxy groups in one molecule is preferable, while an aromatic solid epoxy resin having three or more epoxy groups in one molecule is more preferable.

The solid epoxy resin is preferably a bixylenol type epoxy resin, a naphthalene type epoxy resin, a naphthalene type tetrafunctional epoxy resin, a naphthol novolak type epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, a phenol aralkyl type epoxy resin, a tetraphenylethane type epoxy resin, a phenol phthalimidine type epoxy resin, or a phenolphthalein type epoxy resin.

Specific examples of the solid epoxy resin may include "HP4032H" (a naphthalene type epoxy resin) manufactured by DIC Corp.; "HP-4700" and "HP-4710" (naphthalene type tetrafunctional epoxy resins), which are both manufactured by DIC Corp.; "N-690" (a cresol novolak type epoxy resin) manufactured by DIC Corp.; "N-695" (a cresol novolak type epoxy resin) manufactured by DIC Corp.; "HP-7200", "HP-7200HH", "HP-7200H", and "HP-7200L" (dicyclopentadiene type epoxy resins), which are all manufactured by DIC Corp.; "EXA-7311", "EXA-7311-G3", "EXA-7311-G4", "EXA-7311-G4S", and "HP6000" (naphthylene ether type epoxy resins), which are all manufactured by DIC Corp.; "EPPN-502H" (a trisphenol type epoxy resin) manufactured by Nippon Kayaku Co., Ltd.; "NC7000L" (a naphthol novolak type epoxy resin) manufactured by Nippon Kayaku Co., Ltd.; "NC3000H", "NC3000", "NC3000L", "NC3000FH", and "NC3100" (biphenyl type epoxy resins), which are all manufactured by Nippon Kayaku Co., Ltd.; "ESN475V" (a naphthalene type epoxy resin) manufactured by Nippon Steel Chemical & Materials Co., Ltd.; "ESN485" (a naphthol type epoxy resin) manufactured by Nippon Steel Chemical & Materials Co., Ltd.; "ESN375" (a dihydroxynaphthalene type epoxy resin) manufactured by Nippon Steel Chemical & Materials Co., Ltd.; "YX4000H", "YX4000", "YX4000HK", and "YL7890" (bixylenol type epoxy resins), which are all manufactured by Mitsubishi Chemical Corp.; "YL6121" (a biphenyl type epoxy resin) manufactured by Mitsubishi Chemical Corp.; "YX8800" (an anthracene type epoxy resin) manufactured by Mitsubishi Chemical Corp.; "YX7700" (a phenol aralkyl type epoxy resin) manufactured by Mitsubishi Chemical Corp.; "PG-100" and "CG-500", which are both manufactured by Osaka Gas Chemicals Co., Ltd.; "YL7760" (a bisphenol AF type epoxy resin) manufactured by Mitsubishi Chemical Corp.; "YL7800" (a fluorene type epoxy resin) manufactured by Mitsubishi Chemical Corp.; "jER1010" (a bisphenol A type epoxy resin) manufactured by Mitsubishi Chemical Corp.; "jER1031S" (a tetraphenylethane type epoxy resin) manufactured by Mitsubishi Chemical Corp.; and "WHR991S" (a phenol phthalimidine type epoxy resin) manufactured by Nippon Kayaku Co., Ltd. These may be used singly or as a combination of two or more of these resins.

When the solid epoxy resin and the liquid epoxy resin are used together as the epoxy resin, the mass ratio (solid epoxy resin/liquid epoxy resin) of the solid epoxy resin to the liquid epoxy resin is not particularly limited. The mass ratio (solid epoxy resin/liquid epoxy resin) is preferably 1 or less, more preferably 0.5 or less, still more preferably 0.1 or less, and far still more preferably 0.05 or less, while especially preferably 0.01 or less.

The epoxy equivalent of the epoxy resin is preferably 50 g/eq. to 5,000 g/eq., more preferably 50 g/eq. to 3,000 g/eq., and still more preferably 80 g/eq. to 2,000 g/eq., while especially preferably 110 g/eq. to 1,000 g/eq. The epoxy equivalent is the mass of the resin per one equivalent of the epoxy group. The epoxy equivalent can be measured by the method in accordance with JIS K7236.

From the viewpoint to effectively obtain the intended effects of the present invention, the weight-average molecular weight (Mw) of the epoxy resin is preferably 100 to 5,000, and more preferably 250 to 3,000, while still more preferably 400 to 1,500. The weight-average molecular weight of the resin can be measured with a gel permeation chromatography (GPC) in terms of the polystyrene.

The amount (% by volume) of the epoxy resin relative to 100% by volume of the nonvolatile components in the resin composition is preferably 10% or more by volume, more preferably 15% or more by volume, while especially preferably 20% or more by volume, and is preferably 80% or less by volume, and more preferably 60% or less by volume, while especially preferably 40% or less by volume. When the amount of the epoxy resin is within the above-mentioned range, the relative magnetic permeability of the cured product, as well as the thixotropy and filling property of the resin composition can be especially excellent.

The amount (% by mass) of the epoxy resin relative to 100% by mass of the nonvolatile components in the resin composition is preferably 0.1% or more by mass, and more preferably 1.0% or more by mass, while still more preferably 3.0% or more by mass, and is preferably 50% or less by mass, and more preferably 30% or less by mass, while still more preferably 20% or less by mass. When the amount of the epoxy resin is within the above-mentioned range, the relative magnetic permeability of the cured product, as well as the thixotropy and filling property of the resin composition can be especially excellent.

When the (C) binder resin includes an epoxy resin, the (C) binder resin may further include an epoxy curing agent. The epoxy curing agent means an optional thermosetting resin that can cure the resin composition by reacting with the epoxy resin. Illustrative examples of the epoxy curing agent may include a phenol type curing agent, a carbodiimide type curing agent, an acid anhydride type curing agent, an amine type curing agent, a benzoxazine type curing agent, a cyanate ester type curing agent, and a thiol type curing agent. The epoxy curing agent may be used singly or as a combination of two or more of these curing agents.

Although there is no particular restriction in the phenol type curing agent, preferable are a biphenyl type curing agent, a naphthalene type curing agent, a phenol novolak type curing agent, a naphthylene ether type curing agent, and a phenol type curing agent having a triazine skeleton. Specific examples thereof may include biphenyl type curing agents such as "MEH-7700", "MEH-7810", and "MEH-7851" (manufactured by Meiwa Plastic Industries, Ltd.); naphthalene type curing agents such as "NHN", "CBN", and "GPH" (manufactured by Nippon Kayaku Co., Ltd.), as well as "SN170", "SN180", "SN190", "SN475", "SN485", "SN495", "SN375", and "SN395" (manufactured by Nippon Steel Chemical & Materials Co., Ltd.), and "EXB9500" (manufactured by DIC Corp.); phenol novolak type curing agents such as "TD2090" (manufactured by DIC Corp.); and naphthylene ether type curing agents such as "EXB-6000" (manufactured by DIC Corp.). Specific examples of the phenol type curing agent containing a triazine skeleton may include "LA3018", "LA7052", "LA7054", and "LA1356" (manufactured by DIC Corp.). In particular, a naphthalene type curing agent and a phenol type curing agent having a triazine skeleton are more preferable.

As for the carbodiimide type curing agent, the curing agent having one or more carbodiimide structures, preferably two or more carbodiimide structures, in one molecule may be mentioned . Illustrative examples thereof may include biscarbodiimides including aliphatic biscarbodiimides such as tetramethylene-bis(t-butylcarbodiimide) and cyclohexane-bis(methylene-t-butylcarbodiimide), and aromatic biscarbodiimides such as phenylene-bis(xylylcarbodiimide); and polycarbodiimides including aliphatic polycarbodiimides such as polyhexamethylene carbodiimide, polytrimethylhexamethylene carbodiimide, polycyclohexylene carbodiimide, poly(methylenebiscyclohexylene carbodiimide), and poly(isophorone carbodiimide), and aromatic polycarbodiimides such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylene carbodiimide), poly(tetramethylxylene carbodiimide), poly(methylenediphenylene carbodiimide), and poly[methylenebis(methylphenylene) carbodiimide]. Illustrative examples of the commercially available carbodiimide type curing agent may include "Carbodilite V-02B", "Carbodilite V-03", "Carbodilite V-04K", "Carbodilite V-07", and "Carbodilite V-09", which are all manufactured by Nisshinbo Chemical Inc.; and "Stabaxol P", "Stabaxol P400", and "Hycasyl 510", which are all manufactured by Rhein Chemie GmbH.

Examples of the acid anhydride type curing agent may include the curing agent that has one or more acid anhydride groups in one molecule, and preferably the curing agent that has two or more acid anhydride groups in one molecule. Specific examples of the acid anhydride type curing agent may include phthalic anhydride, tetrahydrophthalic anhydride, hexahydrophthalic anhydride, methyltetrahydrophthalic anhydride, methylhexahydrophthalic anhydride, methyl nadic anhydride, hydrogenated methyl nadic anhydride, trialkyltetrahydrophthalic anhydride, dodecenylsuccinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethyleneglycol bis(anhydrotrimellitate), and polymer-type acid anhydrides such as a styrene-maleic acid resin, which is a copolymer of styrene and maleic acid. Illustrative examples of the commercially available product of the acid anhydride type curing agent may include "HNA-100", "MH-700", "MTA-15", "DDSA", and "OSA", which are all manufactured by New Japan Chemical Co., Ltd.; "YH-306" and "YH-307", which are both manufactured by Mitsubishi Chemical Corp.; and "HN-2200" and "HN-5500", which are both manufactured by Hitachi Chemical Co., Ltd.

As for the amine type curing agent, the curing agent having one or more amino groups, preferably two or more amino groups, in one molecule may be mentioned. Illustrative examples thereof may include an aliphatic amine, a polyether amine, an alicyclic amine, and an aromatic amine; among them, an aromatic amine is preferable. As for the amine type curing agent, a primary amine or a secondary amine is preferable, while a primary amine is more preferable. Specific examples of the amine type curing agent may include 4,4'-methylenebis(2,6-dimethylaniline), 4,4'-diaminodiphenylmethane, 4,4'-diaminodiphenyl sulfone, 3,3'-diaminodiphenyl sulfone, m-phenylenediamine, m-xylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type curing agents may be used; illustrative examples thereof may include "SEIKACURE-S" manufactured by Seika Corp.; "KAYABOND C-200S", "KAYABOND C-100", "KAYAHARD A-A", "KAYAHARD A-B", and "KAYAHARD A-S", which are all manufactured by Nippon Kayaku Co., Ltd.; and "Epicure W" manufactured by Mitsubishi Chemical Corp.

Specific examples of the benzoxazine type curing agent may include "JBZ-OP100D" and "ODA-BOZ", which are both manufactured by JFE Chemical Corp.; "HFB2006M" manufactured by Showa Highpolymer Co., Ltd.; and "P-d" and "F-a", which are both manufactured by Shikoku Chemicals Corp.

Illustrative examples of the cyanate ester type curing agent may include bifunctional cyanate resins such as bisphenol A dicyanate, polyphenol cyanate (oligo(3-methylene-1,5-phenylenecyanate)), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolak, a cresol novolak, and the like; and a prepolymer in which these cyanate resins are partially made to a triazine. Specific examples of the cyanate ester type curing agent may include "PT30" and "PT60" (phenol novolak type polyfunctional cyanate ester resins); "BA230" and "BA230S7S" (prepolymers in which a part or all of bisphenol A dicyanate is made to triazine so as to be a trimer), all of these being manufactured by Lonza Japan Ltd.

Illustrative examples of the thiol type curing agent may include trimethylolpropane tris(3-mercaptopropionate), pentaerythritol tetrakis(3-mercaptobutyrate), and tris(3-mercaptopropyl) isocyanurate.

The reactive group equivalent of the epoxy curing agent is preferably 50 g/eq. to 3,000 g/eq., more preferably 100 g/eq. to 1,000 g/eq., and still more preferably 100 g/eq. to 500 g/eq., while especially preferably 100 g/eq. to 300 g/eq. The reactive group equivalent is the mass of the epoxy curing agent per one equivalent of the reactive group.

The amount of the epoxy curing agent relative to 100% by mass of the nonvolatile components in the resin composition is preferably 40% or less by mass, more preferably 30% or less by mass, and still more preferably 20% or less by mass, while especially preferably 10% or less by mass. The lower limit thereof may be, for example, 0% or more by mass, or 0.01% or more by mass, or 0.1% or more by mass.

The amount (% by volume) of the (C) binder resin relative to 100% by volume of the nonvolatile components in the resin composition is preferably 10% or more by volume, and more preferably 15% or more by volume, while especially preferably 20% or more by volume, and is preferably 80% or less by volume, and more preferably 60% or less by volume, while especially preferably 40% or less by volume. When the amount of the (C) binder resin is within the above-mentioned range, the relative magnetic permeability of the cured product, as well as the thixotropy and filling property of the resin composition can be especially excellent.

The amount (% by mass) of the (C) binder resin relative to 100% by mass of the nonvolatile components in the resin composition is preferably 0.1% or more by mass, and more preferably 1.0% or more by mass, and still more preferably 3.0% or more by mass, while especially preferably 5.0% or more by mass, and is preferably 50% or less by mass, and more preferably 30% or less by mass, while still more preferably 20% or less by mass. When the amount of the (C) binder resin is within the above-mentioned range, the relative magnetic permeability of the cured product, as well as the thixotropy and filling property of the resin composition can be especially excellent.

The amount of the (C) binder resin relative to 100% by mass of the resin components in the resin composition is preferably 60% or more by mass, and more preferably 70% or more by mass, while especially preferably 80% or more by mass, and is preferably 100% or less by mass, and more preferably 95% or less by mass, while especially preferably 90% or less by mass. When the amount of the (C) binder resin is within the above-mentioned range, the relative magnetic permeability of the cured product, as well as the thixotropy and filling property of the resin composition can be especially excellent. The resin components in the resin composition represents the non-volatile components in the resin composition other than the inorganic fillers such as the (A) component and the (B) component.

[5. (D) Epoxy Curing Facilitator]

When the (C) binder resin includes an epoxy resin, the resin composition according to one embodiment of the present invention may further include (D) an epoxy curing facilitator as an optional component. The (D) epoxy curing facilitator has the function to facilitate curing of the epoxy resin.

Illustrative examples of the (D) epoxy curing facilitator may include an imidazole type curing facilitator, a phosphorous type curing facilitator, a urea type curing facilitator, a guanidine type curing facilitator, a metal type curing facilitator, and an amine type curing facilitator. In particular, it is preferable that the (D) epoxy curing facilitator include an imidazole type curing facilitator. The (D) epoxy curing facilitator may be used singly or as a combination of two or more of these facilitators.

Illustrative examples of the imidazole type curing facilitator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of the imidazole compounds with an epoxy resin. Commercially available products may be used as the imidazole type curing facilitator. Illustrative examples thereof may include "1B2PZ", "2MZA-PW", and "2PHZ-PW", which are all manufactured by Shikoku Chemicals Corp., and "P200-H50" manufactured by Mitsubishi Chemical Corp.

Illustrative examples of the phosphorus type curing facilitator may include aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, bis(tetrabutylphosphonium) pyromellitate, tetrabutylphosphonium hydrogen hexahydrophthalate, tetrabutylphosphonium 2,6-bis[(2-hydroxy-5-methylphenyl)methyl]-4-methylphenolate, and di-tert-butylmethylphosphonium tetraphenylborate; aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate; aromatic phosphine-borane complexes such as triphenylphosphine-triphenylborane; aromatic phosphine-quinone adducts such as a triphenylphosphine-p-benzoquinone adduct; aliphatic phosphines such as tributylphosphine, tri-tert-butylphosphine, trioctylphosphine, di-tert-butyl(2-butenyl)phosphine, di-tert-butyl(3-methyl-2-butenyl)phosphine, and tricyclohexylphosphine; and aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl)phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl)phosphine, tris(2,4,6-trimethylphenyl)phosphine, tris(2,6-dimethyl-4-ethoxyphenyl)phosphine, tris(2-methoxyphenyl)phosphine, tris(4-methoxyphenyl)phosphine, tris(4-ethoxyphenyl)phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino) diphenyl ether.

Illustrative examples of the urea type curing facilitator may include: 1,1-dimethylurea; aliphatic dimethylureas such as 1,1,3-trimethylurea, 3-ethyl-1,1-dimethylurea, 3-cyclohexyl-1,1-dimethylurea, and 3-cyclooctyl-1,1-dimethylurea; and aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene) bis(N',N'-dimethylurea), and N,N-(4-methyl-1,3-phenylene) bis(N',N'-dimethylurea) [toluene bisdimethylurea].

Illustrative examples of the guanidine type curing facilitator may include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7-methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide.

Illustrative examples of the metal type curing facilitator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organometallic salt may include zinc octylate, tin octylate, zinc naphthenate, cobalt naphthenate, tin stearate, and zinc stearate.

Illustrative examples of the amine type curing facilitator may include: trialkylamines such as triethylamine and tributylamine; and 4-dimethylaminopyridine, benzyldimethyl amine, 2,4,6-tris(dimethylaminomethyl)phenol, and 1,8-diazabicyclo(5,4,0)-undecene. Commercially available products may be used as the amine type curing facilitator. Illustrative examples thereof may include "MY-25" manufactured by Ajinomoto Fine-Techno Co., Ltd.

The amount (% by volume) of the (D) epoxy curing facilitator relative to 100% by volume of the non-volatile components in the resin composition is preferably 20% or less by volume, and more preferably 10% or less by volume, while especially preferably 5% or less by volume. The lower limit thereof may be, for example, 0% or more by volume, 0.01% or more by volume, 0.1% or more by volume, or 0.5% or more by volume.

The amount (% by mass) of the (D) epoxy curing facilitator relative to 100% by mass of the nonvolatile components in the resin composition is preferably 10% or less by mass, and more preferably 5% or less by mass, while especially preferably 2% or less by mass. The lower limit thereof may be, for example, 0% or more by mass, 0.01% or more by mass, 0.1% or more by mass, or 0.5% or more by mass.

[6. (E) Optional Component]

The resin composition according to one embodiment of the present invention may further include (E) an optional component in combination with the components described above. Illustrative examples of the optional component may include: radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; organic fillers such as a rubber particle; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; ultraviolet absorbers such as a benzotriazole type ultraviolet absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant and a hindered amine type antioxidant; fluorescent whitening agents such as a stilbene derivative; surfactants such as a fluorine type surfactant and a silicone type surfactant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. The (E) optional component may be used singly, or as a combination of two or of these components.

[7. (F) Organic Solvent]

The resin composition according to one embodiment of the present invention may further include, in addition to the nonvolatile components such as the (A) component, the (B) component, the (C) component, the (D) component, and the (E) component described above, (F) an optional organic solvent as a volatile component.

The (F) organic solvent is preferably those that can dissolve the resin components included in the nonvolatile components. Illustrative examples of the (F) organic solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. The (F) organic solvents may be used singly or as a combination of two or more of these solvents with an arbitrary mixing rate.

It is preferable that the amount of the (F) organic solvent be small. For example, the amount of the (F) organic solvent relative to 100% by mass of the nonvolatile components in the resin composition may be 3% or less by mass, 1% or less by mass, 0.5% or less by mass, 0.1% or less by mass, or 0.01% or less by mass. It is especially preferable that the organic solvent be not included in the resin composition. In other words, the amount of the (F) organic solvent is preferably 0% by mass.

[8. Properties of the Resin Composition]

The resin composition according to one embodiment of the present invention can have a low thixotropy. The thixotropy of the resin composition can usually be expressed by the thixotropy index (T.I.). Specifically, the range of the thixotropy index of the resin composition is preferably 2.7 or less, more preferably 2.2 or less, and still more preferably 2.0 or less, while especially preferably 1.8 or less. There is no particular restriction in the lower limit of the thixotropy index. From the viewpoint to form a thick layer of the resin composition, the lower limit of the thixotropy index of the resin composition may be, for example, 1.1 or more, 1.2 or more, 1.3 or more, or 1.4 or more.

The thixotropy index T.I. of the resin composition can be calculated by the following equation (M1) using the viscosity $\eta_{0.5}$ and viscosity $\eta_5$ at rotor speeds of 0.5 rpm and 5 rpm, respectively, measured using an E-type viscometer at 25°C±0.1°C.

$$\mathrm{T.I.} = \eta_{0.5}/\eta_5 \qquad (M1)$$

As for the E-type viscometer, for example, "RE-80U" (3°×R9.7 cone rotor, measurement sample 0.22 mL) manufactured by Toki Sangyo Co., Ltd. may be used. Specifically, the thixotropy index may be measured by the method to be described later in Examples.

The resin composition according to one embodiment of the present invention can have an excellent filling property. The filling property may be evaluated as the property that allows the resin composition to fill well in a through-hole formed in the substrate. For example, the through-hole having a diameter of 500 μm is formed in an FR4 substrate having the thickness of 1 mm. For this through-hole, an evaluation test is performed by printing the resin composition on the substrate at a printing speed of 150 mm/s using a urethane squeegee at 25°C and a vacuum degree of 0.1 Pa. When this evaluation test is conducted, the resin composition described above usually does not stop in the middle of the through-hole, so that the resin composition can fill the entire through-hole. Therefore, when the resin composition is printed on one side (front side) of the substrate, the resin composition can be discharged from the through-hole opening on the other side (back side) of the substrate. Specifically, the evaluation test described above may be conducted by the method to be described later in Examples.

In addition, the resin composition according to one embodiment of the present invention can usually exhibit an excellent filling property when a resin composition layer is formed. For example, a resin sheet including the resin composition layer formed of the resin composition is prepared. This resin sheet is laminated to the substrate having a wiring pattern formed on the surface thereof. In this case, the resin composition layer can fill well around the wiring pattern formed on the surface of the substrate. Therefore, the formation of a space can be usually prevented between the resin composition layer and the wiring pattern.

The cured product formed by curing the resin composition according to one embodiment of the present invention can have excellent magnetic properties. Therefore, the cured product of the resin composition can usually have a high relative magnetic permeability. Specifically, the relative magnetic permeability of the cured product of the resin composition is preferably 7.5 or more, more preferably 8.0 or more, and still more preferably 9.0 or more, while especially preferably 10.0 or more. There is no particular restriction in the upper limit of the relative magnetic permeability; this can be, for example, 30.0 or less, 20.0 or less, or 15.0 or less.

The relative magnetic permeability may be measured under the conditions of the measurement frequency of 100 MHz and the measurement temperature of 23°C, using the cured product obtained by heating the resin composition at 180°C for 90 minutes. Specifically, the relative magnetic permeability may be measured by the method to be explained later in Examples.

[9. Production Method of the Resin Composition]

The resin composition according to one embodiment of the present invention can be produced, for example, by mixing the above-mentioned components. There is no restriction in the order of mixing. The mixing of a part or all of the components may be done simultaneously. During the process of mixing of each component, the temperature may be set as appropriate; for example, temporarily or throughout the entire process, heating and/or cooling may be carried out. Also, during the process of mixing the components, stirring or shaking may be carried out. Furthermore, during the process of mixing the components, or after mixing, deforming may be conducted under low pressure conditions such as under vacuum.

[10. Use of the Resin Composition]

The resin composition according to one embodiment of the present invention may be used, for example, in the form of a pasty resin composition at normal temperature of 23°C. Also, the resin composition layer may be used, for example, in the form of the resin sheet that includes a layer of the resin composition.

The resin composition may be made to a pasty resin composition, for example, by using an organic solvent, or to a pasty resin composition without an organic solvent by using a liquid resin component such as a liquid binder resin. When the organic solvent in the resin composition is small in its amount or not included, generation of voids due to evaporation of the organic solvent can be suppressed, so that the resin composition having an excellent handling property and workability can be obtained.

The resin composition can be used suitably, for example, as the resin composition for filling of a through-hole. The resin composition can be used suitably, for example, as the resin composition for forming an inductor element to manufacture an inductor element.

[11. Resin Sheet]

The resin sheet includes a support and a resin composition layer formed on the support; the resin composition layer being formed of the resin composition.

From the viewpoint of thinning, thickness of the resin composition layer is preferably 250 $\mu$m or less, while more preferably 200 $\mu$m or less. There is no particular restriction in the lower limit of the thickness of the resin composition; this may be, for example, 5 $\mu$m or more, or 10 $\mu$m or more.

Illustrative examples of the support may include a film formed of a plastic material, metal foil, and a releasing paper; among them, a film formed of a plastic material and metal foil are preferable.

When the film formed of a plastic material is used as the support, illustrative examples of the plastic material may include polyesters such as polyethylene terephthalate (hereinafter, this may be simply called "PET") and polyethylene naphthalate (hereinafter, this may be simply called "PEN"); polycarbonate (hereinafter, this may be simply called "PC"); acrylic polymers such as polymethyl methacrylate (PMMA); cyclic polyolefins; triacetyl cellulose (TAC); polyether sulfide (PES); polyether ketone; and polyimide. Among them, polyethylene terephthalate and polyethylene naphthalate are preferable, while inexpensive polyethylene terephthalate is especially preferable.

When the metal foil is used as the support, illustrative examples of the metal foil may include copper foil and aluminum foil, while copper foil is preferable. As for the copper foil, the foil formed of a copper single metal or an alloy of copper with other metal (for example, tin, chromium, silver, magnesium, nickel, zirconium, silicon, or titanium) may be used.

The support may have been subjected to a mat treatment or a corona treatment on the surface to be adhered with the resin composition layer.

As for the support, a support having a releasing layer that includes the releasing layer on the surface to be adhered with the resin composition layer may be used. The releasing agent to be used for the releasing layer of the support having a releasing layer is, for example, one or more releasing agents selected from the group consisting of an alkyd type releasing agent, a polyolefin type releasing agent, a urethane type releasing agent, and a silicone type releasing agent. Commercially available products may be used as the support having a releasing layer; they are, for example, a PET film having the releasing layer including a silicone type releasing agent or an alkyd resin type releasing agent as a main component; here, illustrative examples thereof may include: "PET501010", "SK-1", "AL-5", and "AL-7", which are all manufactured by Lintec Corp.; "Lumirror T60" manufactured by Toray Industries; "Purex" manufactured by Teijin Ltd.; and "Unipeel" manufactured by Unitika Ltd.

Although thickness of the support is not particularly restricted, the thickness is preferably in the range of 5 μm to 75 μm, while more preferably in the range of 10 μm to 60 μm. When the support having a releasing layer is used, total thickness of the support having a releasing layer is preferably within the above-mentioned range.

In the resin sheet, a protection film similar to the support may be further laminated on the surface of the resin composition layer that is not adhered to the support (namely, on the surface opposite to the support). Although thickness of the protection film is not particularly restricted, the thickness is, for example, 1 μm to 40 μm. By laminating the protection film, the surface of the resin composition layer may be prevented from attachment of dirt and formation of a scar. The resin sheet can be rolled up so as to be stored.

The resin sheet can be produced, for example, by applying the resin composition onto the support using application equipment such as a die coater to form the resin composition layer. As needed, the resin composition may be mixed with an organic solvent; and then, this may be applied onto the support. When the organic solvent is used, drying may be carried out as needed after the application.

Drying may be carried out by a method such as heating and hot-air blowing. The drying condition is not particularly restricted; the drying is carried out so as to bring the content of the organic solvent in the resin composition layer to usually 10% or less by mass, while preferably 5% or less by mass. The resin composition layer may be formed, for example, by drying at 50°C to 150°C for 3 minutes to 10 minutes, although the condition is different depending on the components included in the resin composition.

The resin sheet can be rolled up so as to be stored. When the resin sheet has the protection film, usually the resin sheet can be used after removing the protection film.

[12. Circuit Substrate]

The circuit substrate according to one embodiment of the present invention includes the cured product of the resin composition described above. Specific structure of the circuit substrate is not particularly restricted so far as the cured product of the resin composition is included therein. The circuit substrate according to a first example includes a substrate formed with a hole and a cured product of the resin composition filled in this hole. The circuit substrate according to a second example includes a cured product layer formed of the cured product of the resin composition. Hereinafter, the circuit substrates according to the first example and the second example will be explained.

[12.1. Circuit Substrate According to First Example]

The circuit substrate according to the first example includes the substrate formed with a hole and the cured product of the resin composition filled in this hole. This circuit substrate may be produced, for example, by the production method including:

(1) a step of filling the resin composition into the hole of the substrate, and
(2) a step of curing the resin composition to obtain the cured product thereof. The production method of the circuit substrate according to the first example may further include:
(3) a step of polishing the surface of the cured product or of the resin composition,
(4) a step of subjecting the cured product to roughening treatment, and
(5) a step of forming a conductive layer on the roughened surface of the cured product. The steps (1) to (5) are usually carried out in the order of (1) to (5). However, the step (2) may be carried out after the step (3). In the production method of the circuit substrate according to the first example, it is preferable that the cured product be formed by using the pasty resin composition. The explanation hereinafter will be made as to the example of the substrate formed with a through-hole as the hole that penetrates through the substrate in the thickness direction.

<Step (1)>

The step (1) usually includes the step of preparing the substrate formed with the through-hole. The substrate may be prepared by purchasing from the market. Alternatively, the substrate may be prepared by producing it using a suitable material. Hereinafter, the production method of the substrate according to one example will be explained.

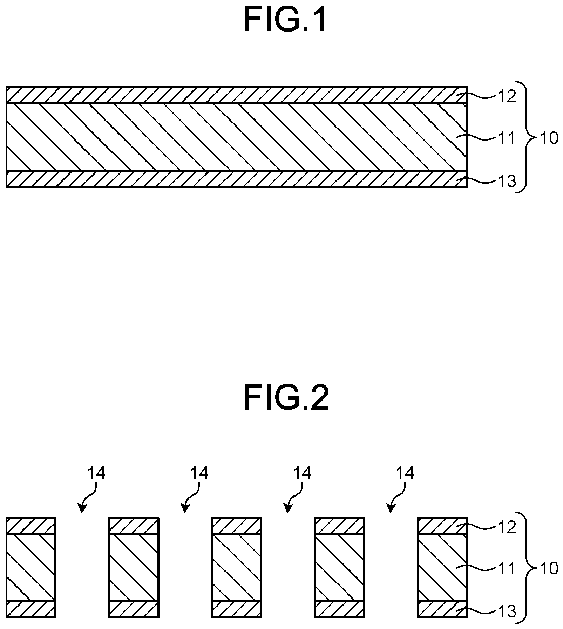

Fig. 1 is a schematic sectional view illustrating a core substrate 10 that is prepared in the production method of the circuit substrate according to the first example of one embodiment of the present invention. The step of preparing the substrate may include the step of preparing the core substrate 10 as illustrated in Fig. 1. The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both the surfaces thereof. Here, the example is illustrated in which a first metal layer 12 and a second metal layer 13 are formed on both the surfaces of the supporting substrate 11. The first metal layer 12 and the second metal layer 13 may be the layers formed by a metal such as copper. The first metal layer 12 and the second metal layer 13 may be, for example, copper foil such as carrier-attached copper foil, or a metal layer formed of a material of a conductive layer to be described later.

Fig. 2 is a schematic sectional view illustrating the core substrate 10 formed with a through-hole 14 in the production method of the circuit substrate according to the first example of one embodiment of the present invention. As illustrated in Fig. 2, the step of preparing the substrate may include a step of forming the through-hole 14 in the core substrate 10. The through-hole 14 can be formed, for example, by drilling, laser irradiation, or plasma irradiation. Usually, the through-hole 14 may be formed by forming a penetrating hole through the core substrate 10. Specifically, formation of the through-hole 14 can be carried out by using a drilling machine that is commercially available. Illustrative examples of the commercially available drilling machine may include "ND-1S211" manufactured by Hitachi Via Mechanics, Ltd.

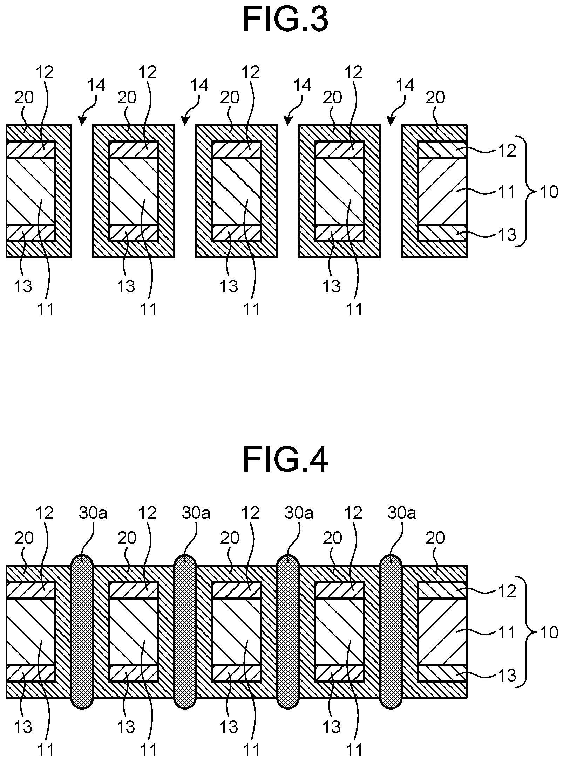

Fig. 3 is a schematic sectional view illustrating the core substrate 10 formed with a plated layer 20 in the through-hole 14 in the production method of the circuit substrate according to the first example of one embodiment of the present invention. After the core substrate 10 is subjected to roughening treatment as needed, the step of preparing the substrate may include the step of forming the plated layer 20, as illustrated in Fig. 3. The roughening treatment may be carried out with any of a dry roughening treatment and a wet roughening treatment. Examples of the dry roughening treatment may include plasma treatment. An example of the wet roughening treatment may be the method in which a swelling treatment by a swelling liquid, a roughening treatment by an oxidant, and a neutralization treatment by a neutralizing solution are carried out in this order. The plated layer 20 may be formed by a plating method. The procedure to form the plated layer 20 by the plating method may be the same as that in formation of the conductive layer at the step (5) to be described later. Here, the explanation will be made as to the example in which the plated layer 20 is formed inside the through-hole 14, on the surface of the first metal layer 12, and on the surface of the second metal layer 13.

Fig. 4 is a schematic sectional view illustrating the state of a resin composition 30a filled in the through-hole of the core substrate 10 in the production method of the circuit substrate according to the first example of one embodiment of the present invention. As illustrated in Fig. 4, the step (1) includes filling the resin composition 30a into the through-hole 14 of the core substrate 10 after the core substrate 10 formed with the through-hole 14 is prepared as described above. The filling may be carried out, for example, by a printing method. Illustrative examples of the printing method may include a method in which the resin composition 30a is printed to the through-hole 14 with a squeegee, a method in which the resin composition 30a is printed via a cartridge, a method in which the resin composition 30a is printed by a mask printing, a roll coating method, and an inkjet method. An excess of the resin composition 30a is usually protruded on or attached to the outside of the through-hole 14a. Therefore, the resin composition 30a may be formed not only inside the through-hole 14a but also outside the through-hole 14a.

<Step (2)>

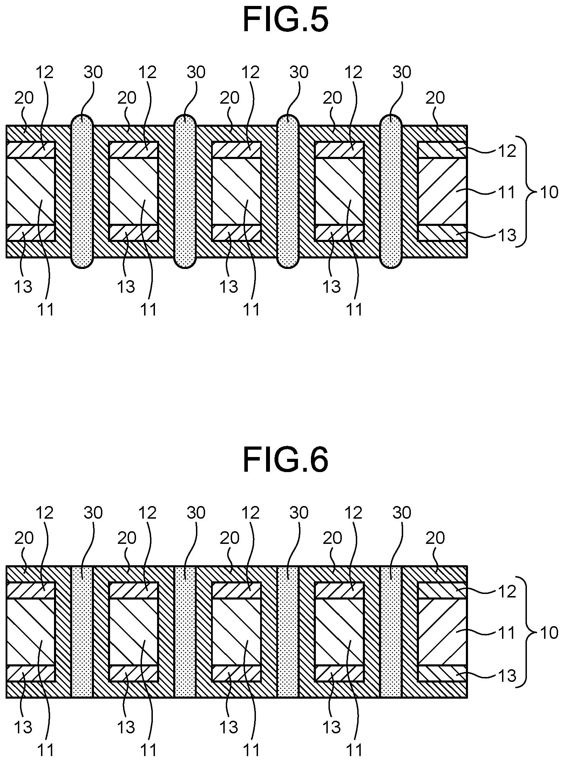

Fig. 5 is a schematic sectional view to explain the step (2) in the production method of the circuit substrate according to the first example of one embodiment of the present invention. The step (2) includes curing the resin composition 30a to form a cured product 30 as illustrated in Fig. 5, after the resin composition 30a is filled into the through-hole 14.

Curing of the resin composition 30a is usually carried out by thermal curing. The thermal curing condition of the resin composition 30a may be set as appropriate so far as curing of the resin composition 30a can be proceeded. The curing temperature is preferably 120°C or higher, and more preferably 130°C or higher, while still more preferably 150°C or higher, and is preferably 245°C or lower, and more preferably 220°C or lower, while still more preferably 200°C or lower. The curing period is preferably 5 minutes or longer, and more preferably 10 minutes or longer, while still more preferably 15 minutes or longer, and is preferably 120 minutes or shorter, and more preferably 110 minutes or shorter, while still more preferably 100 minutes or shorter.

The curing degree of the cured product 30 that is obtained at the step (2) is preferably 80% or more, and more preferably 85% or more, while still more preferably 90% or more. The curing degree can be measured by using, for example, a differential scanning calorimeter.

The production method of the circuit substrate according to the first example may include, after the resin composition 30a is filled into the through-hole 14 and before the resin composition 30a is cured, the step of heating the resin composition 30a at the temperature lower than the curing temperature thereof (preliminary heating step). For example, before curing the resin composition 30a, the resin composition 30a may be preliminarily heated usually at a temperature of 50°C or higher and lower than 120°C (preferably 60°C or higher and 110°C or lower, while more preferably 70°C or higher and 100°C or lower) for the period of usually 5 minutes or longer (preferably 5 minutes to 150 minutes, while more preferably 15 minutes to 120 minutes).

<Step (3) >

Fig. 6 is a schematic sectional view to explain the step (3) in the production method of the circuit substrate according to the first example of one embodiment of the present invention. The step (3) includes polishing an excess of the cured product 30 that is protruded on or attached to the core substrate 10, as illustrated in Fig. 6. Because the excess of the cured product 30 is removed by polishing, the surface of the cured product 30 can be flattened.

As for the polishing method, the method with which an excess of the cured product 30 that is protruded on or attached to the core substrate 10 can be removed may be employed. Illustrative examples of such a polishing method may include a buff polishing method, a belt polishing method, and a ceramic polishing method. Illustrative examples of the buff polishing equipment that is commercially available may include "NT-700IM" manufactured by Ishiihyoki Co., Ltd.

From the viewpoint to enhance the adhesion with the conductive layer, the arithmetic average roughness (Ra) of the polished surface (after thermal curing of the cured product layer) of the cured product 30 is preferably 300 nm or more, and more preferably 350 nm or more, while still more preferably 400 nm or more. The upper limit thereof is preferably 1,000 nm or less, more preferably 900 nm or less, while still more preferably 800 nm or less. The surface roughness (Ra) can be measured, for example, by using a non-contact type surface roughness meter.

When the step (3) is carried out after the step (2), a heat treatment may be carried out to the cured product 30 after the step (2) and before the step (3) in order to further increase the curing degree of the cured product 30. As for the temperature at this heat treatment, the above-mentioned curing temperature may be applied. Specifically, the temperature at the heat treatment is preferably 120°C or higher, and more preferably 130°C or higher, while still more preferably 150°C or higher, and is preferably 245°C or lower, and more preferably 220°C or lower, while still more preferably 200°C or lower. The heat treatment period is preferably 5 minutes or longer, and more preferably 10 minutes or longer, while still more preferably 15 minutes or longer, and is preferably 90 minutes or shorter, and more preferably 70 minutes or shorter, while still more preferably 60 minutes or shorter.

When the step (3) is carried out before the step (2), a preliminary heat treatment of heating at the temperature lower than the curing temperature of the resin composition may be carried out before the step (3). The temperature at the preliminary heat treatment is preferably 100°C or higher, and more preferably 110°C or higher, while still more preferably 120°C or higher, and is preferably 245°C or lower, and more preferably 220°C or lower, while still more preferably 200°C or lower. The heat treatment period is preferably 5 minutes or longer, and more preferably 10 minutes or longer, while still more preferably 15 minutes or longer, and is preferably 90 minutes or shorter, and more preferably 70 minutes or shorter, while still more preferably 60 minutes or shorter.

<Step (4)>

The step (4) includes subjecting the polished surface of the cured product to roughening treatment (desmearing treatment). The procedure and condition of the roughening step are not particularly restricted; for example, the procedure and condition that are used in the production method of a multilayer printed wiring board can be used. At the roughening step, the cured product 30 may be roughened, for example, by carrying out a swelling treatment with a swelling liquid, a roughening treatment with an oxidant, and a neutralization treatment with a neutralizing solution in this order.

Illustrative examples of the swelling liquid that can be used in the roughening step may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid can be carried out, for example, by soaking the cured product 30 into the swelling liquid at 30°C to 90°C for the period of 1 minute to 20 minutes. From the viewpoint to suppress swelling of the resins that constitutes the cured product 30 to a suitable level, it is preferable that the cured product 30 is soaked into the swelling liquid at 40°C to 80°C for the period of 5 minutes to 15 minutes.

As for the oxidant that may be used in the roughening treatment by the oxidant, illustrative examples thereof may include an alkaline permanganate solution having potassium permanganate or sodium permanganate dissolved into an aqueous sodium hydroxide solution. The roughening treatment using the oxidant such as the alkaline permanganate solution may be carried out preferably by soaking the cured product 30 into the oxidant solution heated at 60°C to 80°C for the period of 10 minutes to 30 minutes. The concentration of the permanganate salt in the alkaline permanganate solution is preferably 5% to 10% by mass. Illustrative examples of the oxidant that is commercially available may include alkaline permanganate solutions such as "Concentrate Compact P" and "Dosing Solution Securiganth P", which are both manufactured by Atotech Japan, Co., Ltd.

The neutralizing solution that may be used in the neutralization treatment is preferably an acidic aqueous solution. Illustrative examples of commercially available product of the neutralizing solution may include "Reduction Solution Securiganth P", which is manufactured by Atotech Japan Co., Ltd. The neutralization treatment with the neutralizing solution can be carried out by soaking the treated surface, which has been treated with the roughening treatment using the oxidant solution, into the neutralizing solution at 30°C to 80°C for the period of 5 minutes to 30 minutes. From the viewpoint of workability and the like, it is preferable to soak the cured product 30, which has been treated with the roughening treatment using the oxidant solution, into the neutralizing solution at 40°C to 70°C for the period of 5 minutes to 20 minutes.

From the viewpoint to enhance the adhesion with the conductive layer, the arithmetic average roughness (Ra) of the surface of the cured product 30 after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) can be measured, for example, by using a non-contact type surface roughness meter.

<Step (5)>

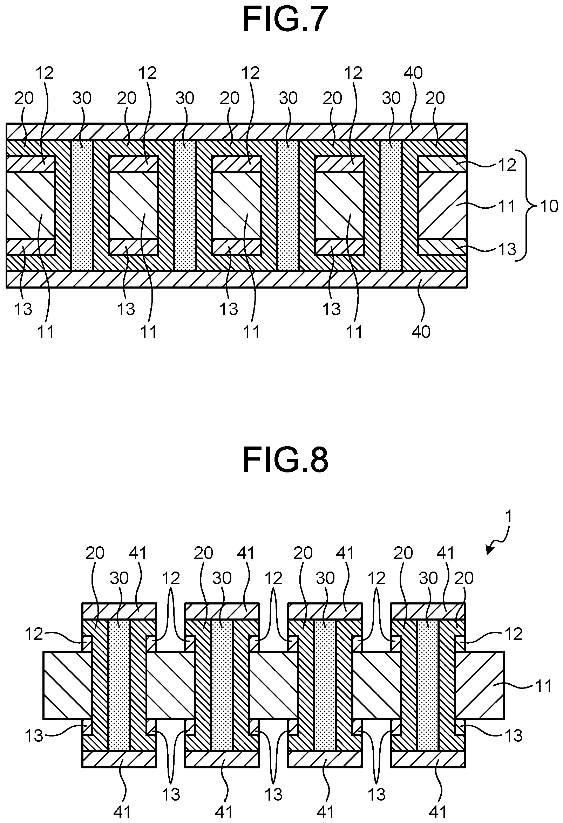

Fig. 7 is a schematic sectional view to explain the step (5) in the production method of the circuit substrate according to the first example of one embodiment of the present invention. The step (5) includes forming a conductive layer 40 on the polished surface of the cured product 30, as illustrated in Fig. 7. Here, the example is illustrated in which the conductive layer 40 is formed not only on the polished surface of the cured product 30 but also on the surface therearound (for example, the surface of the core substrate 10 and the surface of the plated layer 20). In Fig. 7, the example that the conductive layer 40 is formed on both sides of the core substrate 10 is illustrated; but the conductive layer 40 may be formed only on one side of the core substrate 10.

Fig. 8 is a schematic sectional view to explain the step (5) in the production method of the circuit substrate according to the first example of one embodiment of the present invention. The step (5) may include, after the conductive layer 40 is formed, removing a part of the conductive layer 40, the first metal layer 12, the second metal layer 13, and the plated layer 20 by a treatment such as etching to form a patterned conductive layer 41, as illustrated in Fig. 8.

Illustrative examples of the method for forming the conductive layer 40 may include a plating method, a sputtering method, and a vapor deposition method; among these, the plating method is preferable. In a preferable embodiment, the surface of the cured product 30 (and the plated layer 20) is plated with a suitable method such as a semi-additive method or a full additive method, so that the patterned conductive layer 41 having an intended wiring pattern may be formed. Illustrative examples of the material of the conductive layer 40 may include single metals such as gold, platinum, palladium, silver, copper, aluminum, cobalt, chromium, zinc, nickel, titanium, tungsten, iron, tin, and indium; and metal alloys formed of two or more metals selected from the group consisting of gold, platinum, palladium, silver, copper, aluminum, cobalt, chromium, zinc, nickel, titanium, tungsten, iron, tin, and indium. Among these, in view of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy; and more preferable are chromium, nickel, titanium, aluminum, zinc, gold, palladium, silver, and copper, as well as a nickel-chromium alloy; while still more preferable is copper.

Here, the example of the method to form the patterned conductive layer 41 on the polished surface of the cured product 30 will be explained in detail. A plated seed layer is formed on the polished surface of the cured product 30 by electroless plating. Next, onto the plated seed layer thus formed, an electroplated layer is formed by electroplating. Then, as needed, an unnecessary plated seed layer is removed by a treatment such as etching, so that the patterned conductive layer 41 having an intended wiring pattern can be formed. After the patterned conductive layer 41 is formed, with an aim to enhance the adhesion strength of the patterned conductive layer 41, an annealing treatment may be carried out, as needed. The annealing treatment may be carried out, for example, by heating at 150°C to 200°C for the period of 20 minutes to 90 minutes.

From the viewpoint of thinning, the thickness of the patterned conductive layer 41 is preferably 70 $\mu$m or less, more preferably 60 $\mu$m or less, still more preferably 50 $\mu$m or less, and still more preferably 40 $\mu$m or less, while especially preferably 30 $\mu$m or less, 20 $\mu$m or less, 15 $\mu$m or less, or 10 $\mu$m or less. The lower limit thereof is preferably 1 $\mu$m or more, and more preferably 3 $\mu$m or more, while still more preferably 5 $\mu$m or more.

With the method described above, a circuit substrate 1 including the cured product 30 of the resin composition can be produced.

[12.2. Circuit Substrate According to Second Example]

The circuit substrate according to the second example includes the cured product layer formed of the cured product of the resin composition. It is preferable that this cured product layer be formed by using the resin sheet. This circuit substrate may be produced by, for example, the production method including:

(i) a step of laiminating the resin sheet onto an inner layer substrate in such a way that the resin composition layer can be adhered with the inner layer substrate and forming the cured product layer;

(ii) a step of forming a hole in the cured product layer;

(iii) a step of roughening a surface of the cured product layer; and

(iv) a step of forming a conductive layer on the surface of the cured product layer.

<Step (i)>

The step (i) includes laminating the resin sheet onto the inner layer substrate in such a way that the resin composition layer can be adhered with the inner layer substrate and forming the cured product layer. For example, the resin sheet is laminated to the inner layer substrate in such a way that the resin composition layer can be adhered with the inner layer substrate, and then, the resin composition layer is thermally cured to form the cured product layer.

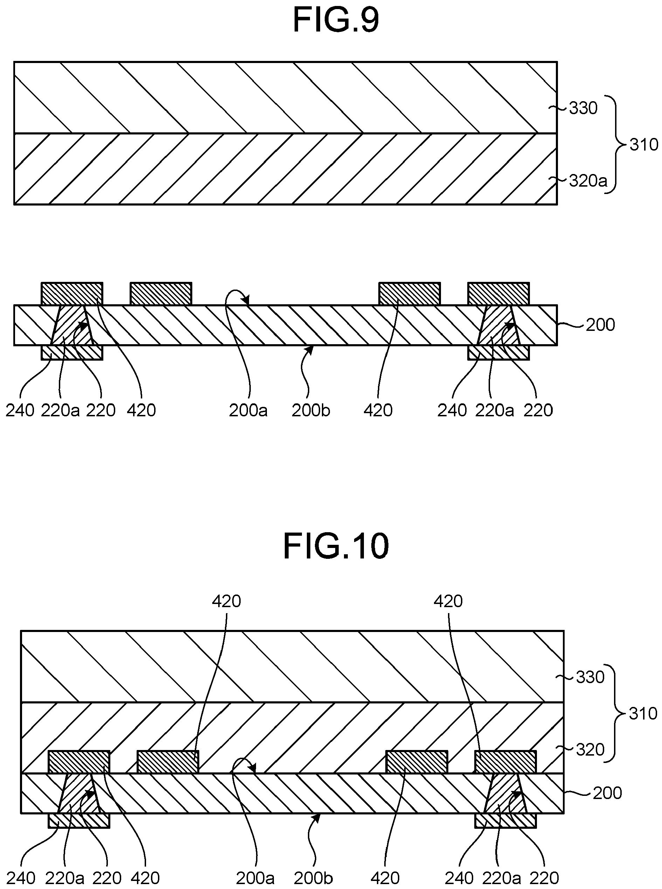

Fig. 9 is a schematic sectional view to explain the step (i) in the production method of the circuit substrate according to the second example of one embodiment of the present invention. As illustrate in Fig. 9, a resin sheet 310 that includes a support 330 and a resin composition layer 320a formed on the support 330 is prepared. Then, the resin sheet 310 is laminated onto an inner layer substrate 200 in such a way that the resin composition layer 320a can be adhered with the inner layer substrate 200.

The inner layer substrate 200 may be an insulating substrate. Illustrative examples of the inner layer substrate 200 may include insulating substrates such as a glass epoxy substrate, a metal substrate, a polyester substrate, a polyimide substrate, a BT resin substrate, and a thermosetting type polyphenylene ether substrate. The inner layer substrate 200 may be an inner circuit substrate having a wiring or the like incorporated in the thickness thereof.

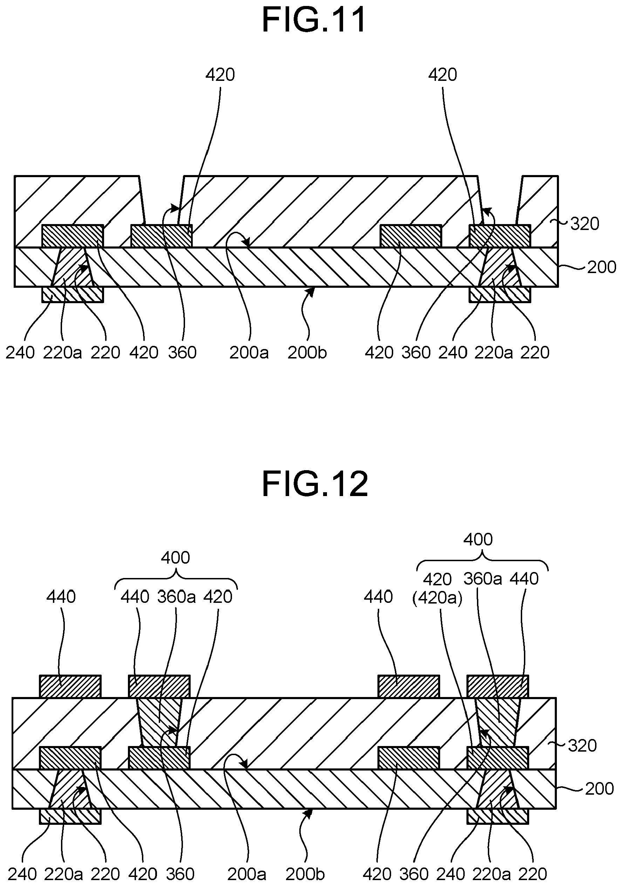

The inner layer substrate 200 in this example includes a first conductive layer 420 formed on a first main surface 200a and an outside terminal 240 formed on a second main surface 200b. The first conductive layer 420 may include a plurality of wirings. Note that, in the example illustrated by Fig. 9, only the wiring that constitutes a coil-shaped conductive structural body 400 (see Fig. 12) of an inductor element is illustrated. The outside terminal 240 may be the terminal to electrically connect to an outside device or the like that is not illustrated in the drawing. The outside terminal 240 can be constructed as a part of the conductive layer formed on the second main surface 200b.

Conductive materials that may construct the first conductive layer 420 and the outside terminal 240 are, for example, the same as the materials of the conductive layer that have been explained in the first example.

The first conductive layer 420 and the outside terminal 240 may have any of a monolayer structure and a multilayer structure in which two or more layers formed of single metal layers or alloy layers formed of different metals or alloys are laminated. Thicknesses of the first conductive layer 420 and of the outside terminal 240 may be the same as those of a second conductive layer 440 to be described later.

The line (L)/space (S) ratio of the first conductive layer 420 and the outside terminal 240 is not particularly restricted; from the viewpoint to reduce irregularity of the surface so as to obtain the cured product layer having excellent smoothness, the ratio is usually 900/900 $\mu$m or less, preferably 700/700 $\mu$m or less, more preferably 500/500 $\mu$m or less, and still more preferably 300/300 $\mu$m or less, while far still more preferably 200/200 $\mu$m or less. Although the lower limit of the line/space ratio is not particularly restricted, from the viewpoint to enhance the filling property of the resin composition layer into the space, the ratio is preferably 1/1 $\mu$m or more.

The inner layer substrate 200 may have a plurality of through-holes 220 that are formed so as to penetrate through the inner layer substrate 200 from the first main surface 200a to the second main surface 200b. In the through-hole 220, an in-the-through-hole wiring 220a is formed. The in-the-through-hole wiring 220a electrically connects the first conductive layer 420 with the outside terminal 240.

Adhesion of the resin composition layer 320a with the inner layer substrate 200 may be carried out, for example, by hot-pressing of the resin sheet 310 to the inner layer substrate 200 by pressing from the side of the support 330. Illustrative examples of the member for hot-pressing of the resin sheet 310 to the inner layer substrate 200 (hereinafter, this member may be called "hot-pressing member") may include a heated metal plate (stainless steel (SUS) mirror plate and the like) and a heated metal roll (SUS roll). Here, it is preferable that the hot-pressing member be not pressed in direct contact with the resin sheet 310 but be pressed via an sheet or the like formed of an elastic material such as a heat-resistant rubber so that the resin sheet 310 can well follow the irregularity of the surface of the inner layer substrate 200.

The temperature at the time of the hot-press adhesion is preferably in the range of 80°C to 160°C, and more preferably in the range of 90°C to 140°C, while still more preferably in the range of 100°C to 120°C; and the pressure at the time of the hot-pressing is preferably in the range of 0.098 MPa to 1.77 MPa, while more preferably in the range of 0.29 MPa to 1.47 MPa; and the period at the time of the hot-press adhesion is preferably in the range of 20 seconds to 400 seconds, while more preferably in the range of 30 seconds to 300 seconds. The adhesion of the resin sheet with the inner layer substrate is carried out preferably under an evacuated condition with the pressure of 26.7 hPa or less.

Adhesion of the resin composition layer 320a of the resin sheet 310 with the inner layer substrate 200 may be carried out by using a commercially available vacuum laminator. Illustrative examples of the commercially available vacuum laminator may include a vacuum press type laminator manufactured by Meiki Co., Ltd. and a vacuum applicator manufactured by Nikko-Materials Co., Ltd.

After adhesion of the resin sheet 310 with the inner layer substrate 200, for example, the laminated resin sheet 310 may be flattened by pressing with the hot-pressing member from the side of the support 330 under a normal pressure (under the atmospheric pressure). The pressing conditions at the flattening treatment may be the same as the hot-press adhering condition in the beforementioned lamination. The flattening treatment may be carried out by using a commercially available laminator. The lamination and the flattening treatment may be carried out continuously by using the commercially available vacuum laminator described before.

Fig. 10 is a schematic sectional view to explain the step (i) in the production method of the circuit substrate according to the second example of one embodiment of the present invention. After the resin sheet 310 is laminated to the inner layer substrate 200, the resin composition layer 320a is thermally cured to form the cured product layer. In this example, as illustrated in Fig. 10, the resin composition layer 320a having been adhered with the inner layer substrate 200 is thermally cured to form a first cured product layer 320.

Conditions of the thermal curing of the resin composition layer 320a may be set as appropriate so far as cureing of the resin composition can be proceeded. The curing temperature is preferably 120°C or higher, and more preferably 130°C or higher, while still more preferably 150°C or higher, and is preferably 245°C or lower, and more preferably 220°C or lower, while still more preferably 200°C or lower. The curing period is preferably 5 minutes or longer, and more preferably 10 minutes or longer, while still more preferably 15 minutes or longer, and is preferably 120 minutes or shorter, and more preferably 110 minutes or shorter, while still more preferably 100 minutes or shorter.

The support 330 may be removed between after the thermal curing at the step (i) and the step (ii), or after the step (ii).

From the viewpoint to enhance the adhesion with the plating, the arithmetic average roughness (Ra) of the cured product layer before the roughening treatment is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) can be measured, for example, by using a non-contact type surface roughness meter.

The step (i) may include applying, in place of the resin sheet, the resin composition onto the inner layer substrate 200 by using an application device such as a die coater, and then thermally curing to form the cured product layer.

<Step (ii)>

Fig. 11 is a schematic sectional view to explain the step (ii) in the production method of the circuit substrate according to the second example of one embodiment of the present invention. The step (ii), as illustrated in Fig. 11, includes forming a hole in the first cured product layer 320 to form a via hole 360. The via hole 360 can be a channel to electrically connect the first conductive layer 420 with the second conductive layer 440 to be described later. Formation of the via hole 360 may be carried out by using a drill, a laser, a plasma, or the like. The size and shape of the hole may be determined as appropriate in accordance with a design of the printed wiring board.

<Step (iii)>

At the step (iii), the surface of the cured product layer formed with the via hole is roughened. The roughening treatment at the step (iii) may be carried out with the same method as explained in the step (4) of the first example.

From the viewpoint to enhance the adhesion with a plating, the arithmetic average roughness (Ra) of the cured product layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) can be measured, for example, by using a non-contact type surface roughness meter.

<Step (iv)>

Fig. 12 is a schematic sectional view to explain the step (iv) in the production method of the circuit substrate according to the second example of one embodiment of the present invention. As illustrated in Fig. 12, at the step (iv), the second conductive layer 440 is formed on the first cured product layer 320.

The conductive materials capable of constructing the second conductive layer 440 may be the same as those of the conductive layer explained in the first example.

From the viewpoint of thinning, the thickness of the second conductive layer 440 is preferably 70 μm or less, more preferably 60 μm or less, still more preferably 50 μm or less, and far still more preferably 40 μm or less, while especially preferably 30 μm or less, 20 μm or less, 15 μm or less, or 10 μm or less. The lower limit thereof is preferably

1 μm or more, and more preferably 3 μm or more, while still more preferably 5 μm or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as by a full additive method. When the second conductive layer 440 is formed by the wet plating method, the second conductive layer 440 having an intended wiring pattern can be formed. At this step, an in-the-via-hole wiring 360a is concurrently formed in the via hole 360.

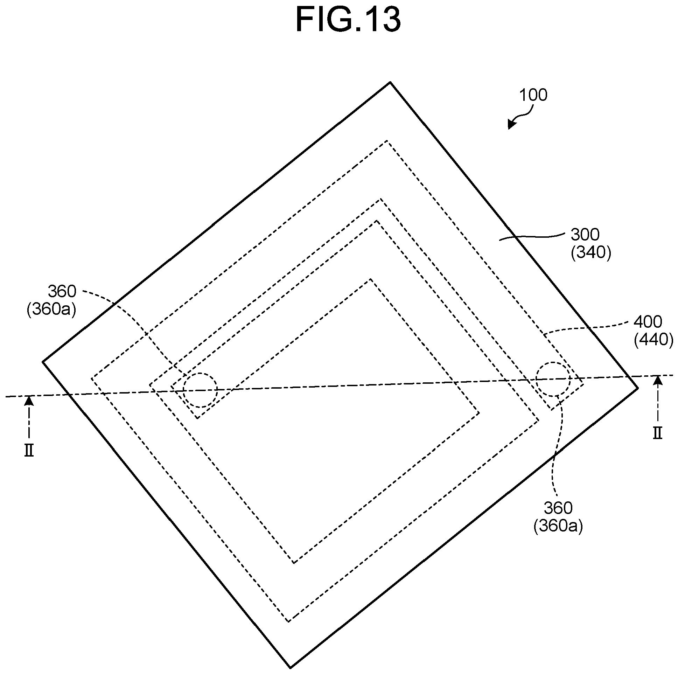

The first conductive layer 420 and the second conductive layer 440 may be formed, for example, spirally, as illustrated in Fig. 13 to Fig. 15 to be described later as one example. In one example, one end in the center side of the spiral wiring part of the second conductive layer 440 is electrically connected through the in-the-via-hole wiring 360a to one end in the center side of the spiral wiring part of the first conductive layer 420. Other end in the outer circumferential side of the spiral wiring part of the second conductive layer 440 is electrically connected through the in-the-via-hole wiring 360a to a land 420a of the first conductive layer 42. Therefore, the other end in the outer circumferential side of the spiral wiring part of the second conductive layer 440 is electrically connected to the outside terminal 240 via the in-the-via-hole wiring 360a, the land 420a, and the in-the-through-hole wiring 220a.

The coil-shaped conductive structural body 400 is composed of the spiral wiring part that is a part of the first conductive layer 420, the spiral wiring part that is a part of the second conductive layer 440, and the in-the-via-hole wiring 360a that electrically connects between the spiral wiring part of the first conductive layer 420 and the spiral wiring part of the second conductive layer 440.

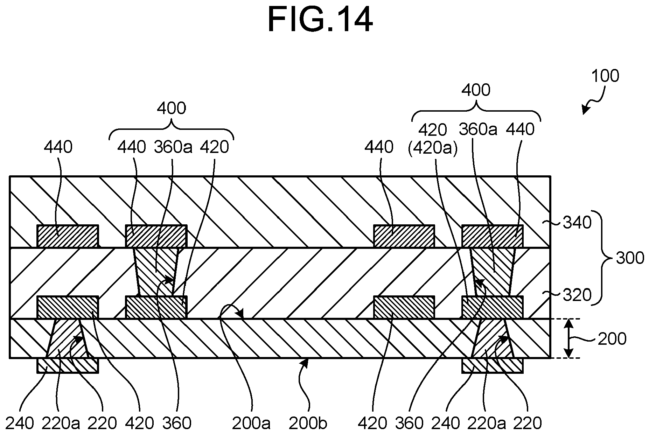

After the step (iv), a step of further forming the cured product layer on the conductive layer may be carried out. Specifically, as illustrated in Fig. 14 as one example, a second cured product layer 340 is formed on the first cured product layer 320 formed with the second conductive layer 440 and the in-the-via-hole wiring 360a. The second cured product layer may be formed with the same step as the step that has already been explained. With the method described above, a circuit substrate 100, which includes the first cured product layer 320 and the second cured product layer 340 formed of the cured product of the resin composition, can be produced.

[13. Inductor Substrate]

The inductor substrate includes the circuit substrate described above. When the inductor substrate includes the circuit substrate that is obtained by the production method of the circuit substrate according to the first example as described above, the inductor substrate may have the inductor pattern that is formed by a conductor around at least a part of the cured product of the resin composition. In this case, the inductor substrate may include the inductor element that is composed of the inductor pattern, which is formed, for example, by at least a part of the first metal layer 12, the second metal layer 13, the plated layer 20, and the patterned conductive layer 41, and of a core part that is formed by the cured product 30 that is surrounded by the inductor pattern. For such an inductor substrate, the one described, for example, in Japanese Patent Application Laid-open No. 2016-197624 can be applied.

When the circuit substrate that is obtained by the production method of the circuit substrate according to the second example is included, the inductor substrate may include the cured product layer and the conductive structural body having at least a part thereof embedded into the cured product layer. The inductor substrate may include the inductor element that is composed of this conductive structural body and a part of the cured product layer that is extendedly present in a thickness direction of the cured product layer and is surrounded with the conductive structural body.

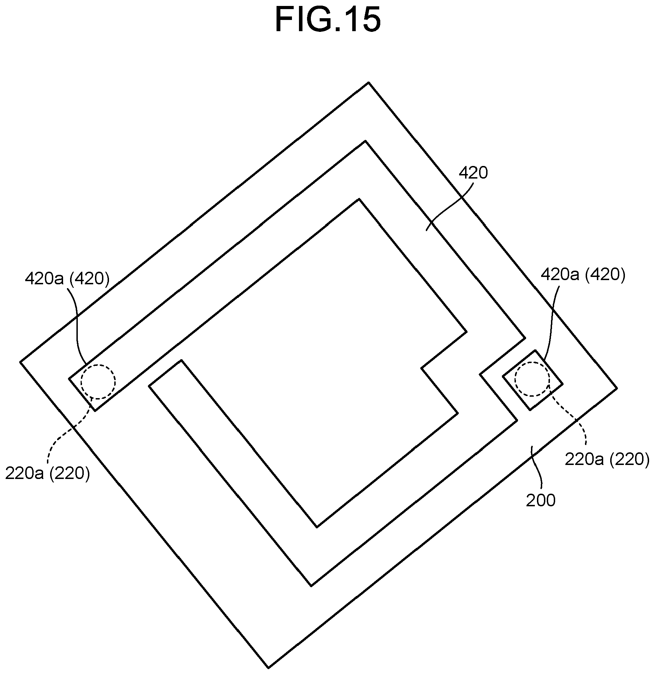

Fig. 13 is a schematic plane view of the circuit substrate 100 possessed by the inductor substrate, observed from one side in the thickness direction thereof. Fig. 14 is a schematic view illustrating a cut edge face of the circuit substrate 100 that is cut at the place indicated by the II-II one dot chain line in Fig. 13. Fig. 15 is a schematic plane view to explain the composition of the first conductive layer 420 of the circuit substrate 100 included in the inductor substrate.

As illustrated in Fig. 13 and Fig. 14 as one example, the circuit substrate 100 has a plurality of the cured product layers (the first cured product layer 320 and the second cured product layer 340) and a plurality of the conductive layers (the first conductive layer 420 and the second conductive layer 440); namely, the curcuit substrate 100 may be a build-up wiring board having a build-up cured product layer and a build-up conductive layer. In addition, the circuit substrate 100 includes an inner layer substrate 200.

As illustrated in Fig. 14, the first cured product layer 320 and the second cured product layer 340 constitute a magnetic portion 300, which can be regarded as an integrated cured product layer. Therefore, the coil-shaped conductive structural body 400 is formed such that at least a part thereof is embedded into the magnetic portion 300. Namely, in the circuit substrate 100 according to this example, the inductor element is composed of the coil-shaped conductive structural body 400 and a core part, which is extendedly present in the thickness direction of the magnetic portion 300 and is a part of the magnetic portion 300 that is surrounded with the coil-shaped conductive structural body 400.

As illustrated in Fig. 15 as one example, the first conductive layer 420 includes the spiral wiring part to constitute the coil-shaped conductive structural body 400, and the square-shaped land 420a that is electrically connected to the in-the-through-hole wiring 220a. According to this example, the spiral wiring part includes a linear portion, a bent portion that is bent at a right angle, and a detour portion that detours the land 420a. In addition, outline of the entire spiral wiring part of the first conductive layer 420 is in a substantially square shape and has a shape that the wiring port is whirled in the anticlockwise direction from a center side to an outer side thereof.

Similarly, the second conductive layer 440 is formed on the first cured product layer 320. The second conductive layer 440 includes the spiral wiring part to constitute the coil-shaped conductive structural body 400. In Fig. 13 or Fig. 14, the spiral wiring part includes a linear portion and a bent portion that is bent at a right angle. In Fig. 13 or Fig. 14, outline of the entire spiral wiring part of the second conductive layer 44 is in a substantially square shape and has a shape that the wiring part is whirled clockwise from a center side to an outer side thereof.

The inductor substrate described above can be used as the wiring board to mount an electronic part such as a semiconductor chip, and can also be used as a (multilayered) printed wiring board that uses this wiring board as the inner layer substrate. In addition, the inductor substrate can also be used as a chipped inductor part obtained by dicing the wiring board, and can also be used as a printed wiring board that is surface-mounted with the chipped inductor part.

In addition, by using the wiring board, semiconductor devices with various embodiments may be produced. The semiconductor devices having the wiring board can be suitably used in electric products (for example, a computer, a cell phone, a digital camera, and a television), carriers (for example, a motor bike, an automobile, a train, a marine ship, and an airplane), and so forth.

EXAMPLES

The present invention will be explained in detail by Examples below. Note that the present invention is not limited to Examples to be described hereinafter.

In the description below, "part" and "%" that describe quantities mean "part by mass" and "% by mass", respectively, unless otherwise specifically mentioned. The operations described below were conducted at normal temperature (23°C), at a normal pressure (1 atm), and in the atmospheric air, unless otherwise specifically mentioned.

[Example 1]

Thirty parts by mass of soft magnetic nano alloy powder a1 (FeSiCr type alloy powder "G00129D", manufactured by JFE Mineral Co., Ltd., average particle diameter of 0.2 $\mu$m, true specific gravity of 7, specific surface area of 9 $m^2$/g), 70 parts by mass of soft magnetic powder b1 (FeSiCr type alloy powder "AW02- 08PF03", manufactured by Epson Atmix Corp., average particle diameter of 3 $\mu$m, true specific gravity of 7, specific surface area of 0.65 $m^2$/g), 3 parts by mass of liquid epoxy resin c1 ("ZX-1059", mixture of bisphenol A type epoxy resin and bisphenol F type epoxy resin, manufactured by Nippon Steel Chemical & Material Co., Ltd., specific gravity of 1.1), 3 parts by mass of liquid epoxy resin c2 ("EP-4088S", glycidyl ether type aliphatic epoxy resin, manufactured by ADEKA Corp., specific gravity of 1.1), 1 part by mass of liquid epoxy resin c3 ("630", glycidyl ether type aromatic epoxy resin, manufactured by Mitsubishi Chemical Corp., specific gravity of 1.1), and 1 part by mass of a curing facilitator ("2MZA-PW", imidazole type curing facilitator, manufactured by Shikoku Chemical Corp., specific gravity of 1.0) were mixed and uniformly dispersed with a high-speed rotary mixer to produce the resin composition 1 in the pasty form.

[Example 2]

Resin composition 2 was produced by the same way as Example 1, except that 70 parts by mass of soft magnetic powder b2 (FeSiCr type alloy powder "KUAMET 6B2-53um", manufactured by Epson Atmix Corp., average particle diameter of 25 $\mu$m, true specific gravity of 7, specific surface area of 0.5 $m^2$/g) was used in place of the soft magnetic powder b1.

[Example 3]

Resin composition 3 was produced by the same way as Example 1, except that 70 parts by mass of soft magnetic powder b3 (FeSiCr type alloy powder "KUAMET NC1-53um", manufactured by Epson Atmix Corp., average particle diameter of 25 $\mu$m, true specific gravity of 7, specific surface area of 0.55 $m^2$/g) was used in place of the soft magnetic powder b1.

[Example 4]

The resin composition 4 was produced by the same way as Example 1, except that 70 parts by mass of soft magnetic powder b4 (FeNi type alloy powder "Fe-50Ni", manufactured by DOWA Electronics Materials Co., Ltd., average particle diameter of 3 μm, true specific gravity of 8, specific surface area of 0.8 m$^2$/g) was used in place of the soft magnetic powder b1.

[Example 5]

Resin composition 5 was produced by the same way as Example 1, except that 70 parts by mass of soft magnetic powder b5 (MnZn type ferrite powder "MZ05S", manufactured by Powdertech Co., Ltd., average particle diameter of 5 μm, true specific gravity of 5, specific surface area of 0.4 m$^2$/g) was used in place of the soft magnetic powder b1.

[Example 6]

Resin composition 6 was produced by the same way as Example 1, except that 70 parts by mass of soft magnetic powder b6 (MnZn type ferrite powder "MZ10S", manufactured by Powdertech Co., Ltd., average particle diameter of 10 μm, true specific gravity of 5, specific surface area of 0.3 m$^2$/g) was used in place of the soft magnetic powder b1.

[Example 7]

Resin composition 7 was produced by the same way as Example 1, except that 70 parts by mass of soft magnetic powder b7 (Mn type ferrite powder "M05S", manufactured by Powdertech Co., Ltd., average particle diameter of 5 μm, true specific gravity of 5, specific surface area of 0.5 m$^2$/g) was used in place of the soft magnetic powder b1.

[Example 8]

Resin composition 8 was produced by the same way as Example 1 except that the amount of the soft magnetic nano alloy powder a1 was changed to 5 parts by mass, and that the amount of the soft magnetic powder b1 was changed to 95 parts by mass.

[Example 9]

Resin composition 9 was produced by the same way as Example 1 except that the amount of the soft magnetic nano alloy powder a1 was changed to 50 parts by mass, and that the amount of the soft magnetic powder b1 was changed to 50 parts by mass.

[Example 10]

Resin composition 10 was produced by the same way as in Example 1, except that 30 parts by mass of soft magnetic nano alloy powder a2 (FeSiCr type alloy powder "G00212D", manufactured by JFE Mineral Co., Ltd., average particle diameter of 0.5 μm, true specific gravity of 7, specific surface area of 3 m$^2$/g) was used in place of the soft magnetic nano alloy powder a1.

[Example 11]

Resin composition 11 was produced by the same way as Example 1, except that 30 parts by mass of soft magnetic nano alloy powder a3 (FeSiCr type alloy powder "G00220DC", manufactured by JFE Mineral Co., Ltd., average particle diameter of 0.7 μm, true specific gravity of 8, specific surface area of 5 m$^2$/g) was used in place of the soft magnetic nano alloy powder a1.

[Comparative Example 1]

Resin composition 12 was produced by the same way as Example 1, except that 30 parts by mass of soft magnetic nano powder a4 (Mn type ferrite powder "M001", manufactured by Powdertech Co., Ltd., average particle diameter of 0.2 μm, true specific gravity of 5, specific surface area of 11 m$^2$/g) was used in place of the soft magnetic nano alloy powder a1.

[Comparative Example 2]

Resin composition 13 was produced by the same way as Example 1, except that 30 parts by mass of soft magnetic nano powder a5 (MnMgSr type ferrite powder "E001", manufactured by Powdertech Co., Ltd., average particle diameter of 0.2 $\mu$m, true specific gravity of 5, specific surface area of 15 m$^2$/g) was used in place of the soft magnetic nano alloy powder a1.

[Comparative Example 3]

Resin composition 14 was produced by the same way as Example 1, except that 5 parts by mass of the soft magnetic nano powder a4 (Mn type ferrite powder "M001", manufactured by Powdertech Co., Ltd., average particle diameter of 0.2 $\mu$m, true specific gravity of 5, specific surface area of 11 m$^2$/g) was used in place of the soft magnetic nano alloy powder a1, and that the amount of the soft magnetic powder b1 was changed to 95 parts by mass.

[Comparative Example 4]

Resin composition 15 was produced by the same way as Example 1, except that 50 parts by mass of the soft magnetic nano-powder a4 (Mn type ferrite powder "M001", manufactured by Powdertech Co., Ltd., average particle diameter of 0.2 $\mu$m, true specific gravity of 5, specific surface area of 11 m$^2$/g) was used in place of the soft magnetic nano alloy powder a1, and that the amount of the soft magnetic powder b1 was changed to 50 parts by mass.

[Comparative Example 5]

Resin composition 16 was produced by the same way as Example 1, except that 5 parts by mass of silica (silica "A200", manufactured by Nippon Aerosil Co., Ltd., average particle diameter of 0.1 $\mu$m, true specific gravity of 2.2, specific surface area of 200 m$^2$/g) was used in place of the soft magnetic nano alloy powder a1, and that the amount of the soft magnetic powder b1 was changed to 95 parts by mass.

[Test Example 1: Measurement of Relative Magnetic Permeability]

A polyethylene terephthalate (PET) film ("PET501010"; thickness of 50 $\mu$m; manufactured by Lintec Corp.) having a releasing surface treated with a silicone type releasing agent was prepared as the support. Each resin composition was uniformly applied onto the releasing surface of the PET film by using a doctor blade such that the thickness of the resin composition layer after drying was 100 $\mu$m to obtain a resin sheet. The resin sheet thus obtained was heated at 180°C for 90 minutes to thermally cure the resin composition layer, which was then followed by removing the support to obtain the sheet-shaped cured product. The cured product thus obtained was cut into a toroidal type specimen having the outer diameter of 19 mm and the inner diameter of 9 mm to obtain an evaluation sample. The relative magnetic permeability ($\mu$') of this evaluation sample was measured by using an analysis instrument ("16454A E4991B"; manufactured by Keysight Technologies, Inc.) at room temperature of 23°C with the measurement frequency of 100 MHz.

[Test Example 2: Measurement of Thixotropy Index]

Each resin composition was kept at 25°C $\pm$ 0.1°C; and the viscosity of each resin composition was measured using an E-type viscometer ("RE-80U", manufactured by Toki Sangyo Co., Ltd., 3° $\times$ R9.7 cone rotor (0.22 mL of measurement sample)). Viscosity measurements were performed at the rotor speeds of 0.5 rpm and 5 rpm, respectively. The viscosity $\eta_{0.5}$ measured at the rotor speed of 0.5 rpm and the viscosity $\eta_5$ measured at the rotor speed of 5 rpm were used to calculate the thixotropy index (T.I.) using the following equation.

$$\text{T.I.} = (\text{viscosity } \eta_{0.5} \text{ at rotor speed } 0.5 \text{ rpm})/(\text{viscosity } \eta_5 \text{ at rotor speed } 5 \text{ rpm})$$

[Test Example 3: Evaluation of Filling Property]

By using the LS-340VTVA type vacuum screen printer manufactured by NEWLONG SEIMITSU KOGYO Co., Ltd., the filling property of each resin composition was evaluated by the following method.

The FR4 substrate (thickness of 1 mm) formed with a through-hole having the diameter of 500 $\mu$m was prepared. At 25°C in a vacuum of 0.1 Pa, each resin composition was printed on the substrate using a urethane squeegee at the printing speed of 150 mm/s, so that the through-hole was filled with the resin composition. After printing, the resin composition was cured at 190°C for 90 minutes. Thereafter, the substrate was cut at the part where the through-hole was formed, and the cross-section thereof was observed to evaluate the filling property according to the following standard.

"Good": The resin composition passes through the through-hole and is discharged to the back surface of the substrate.

"Poor": The resin composition is not discharged to the back surface of the substrate.

[Results:]

The results of Examples and Comparative Examples are summarized in Tables below. In the Tables, the abbreviations have the following meanings.

Volume ratio B/A: Volume ratio of the soft magnetic nano powder and the soft magnetic powder (soft magnetic powder/soft magnetic nano powder)

Weighted average (volume basis): Weighted average of the BET specific surface area of the soft magnetic nano powder and the BET specific surface area of the soft magnetic powder on a volume basis.

Weighted average (mass basis): Weighted average of the BET specific surface area of the soft magnetic nano powder and the BET specific surface area of the soft magnetic powder on a mass basis.

Table 1

[Table 1. Results of Examples]

| | specific gravity | Example | | | | | | | | | | |
|---|---|---|---|---|---|---|---|---|---|---|---|---|
| | | 1 | 2 | 3 | 4 | 5 | 6 | 7 | 8 | 9 | 10 | 11 |
| soft magnetic nano powder | | | | | | | | | | | | |
| a1 | 7.0 | 30 | 30 | 30 | 30 | 30 | 30 | 30 | 5 | 50 | | |
| a2 | 7.0 | | | | | | | | | | 30 | |
| a3 | 8.0 | | | | | | | | | | | 30 |
| a4 | 5.0 | | | | | | | | | | | |
| a5 | 5.0 | | | | | | | | | | | |
| soft magnetic powder | | | | | | | | | | | | |
| b1 | 7.0 | 70 | | | | | | | 95 | 50 | 70 | 70 |
| b2 | 7.0 | | 70 | | | | | | | | | |
| b3 | 7.0 | | | 70 | | | | | | | | |
| b4 | 8.0 | | | | 70 | | | | | | | |
| b5 | 5.0 | | | | | 70 | | | | | | |
| b6 | 5.0 | | | | | | 70 | | | | | |
| b7 | 5.0 | | | | | | | 70 | | | | |
| silica | 2.2 | | | | | | | | | | | |
| epoxy resin | | | | | | | | | | | | |
| c1 | 1.1 | 3 | 3 | 3 | 3 | 3 | 3 | 3 | 3 | 3 | 3 | 3 |
| c2 | 1.1 | 3 | 3 | 3 | 3 | 3 | 3 | 3 | 3 | 3 | 3 | 3 |
| c3 | 1.1 | 1 | 1 | 1 | 1 | 1 | 1 | 1 | 1 | 1 | 1 | 1 |
| curing facilitator | 1.0 | 1 | 1 | 1 | 1 | 1 | 1 | 1 | 1 | 1 | 1 | 1 |
| soft magnetic nano powder (% bv mass) | | 27.8 | 27.8 | 27.8 | 27.8 | 27.8 | 27.8 | 27.8 | 4.6 | 46.3 | 27.8 | 27.8 |
| soft magnetic powder (% by mass) | | 64.8 | 64.8 | 64.8 | 64.8 | 64.8 | 64.8 | 64.8 | 88.0 | 46.3 | 64.8 | 64.8 |
| epoxy resin (% by mass) | | 6.5 | 6.5 | 6.5 | 6.5 | 6.5 | 6.5 | 6.5 | 6.5 | 6.5 | 6.5 | 6.5 |

(continued)

| | specific gravity | Example | | | | | | | | | | |
|---|---|---|---|---|---|---|---|---|---|---|---|---|
| | | 1 | 2 | 3 | 4 | 5 | 6 | 7 | 8 | 9 | 10 | 11 |
| curing facilitator (% by mas) | | 0.9 | 0.9 | 0.9 | 0.9 | 0.9 | 0.9 | 0.9 | 0.9 | 0.9 | 0.9 | 0.9 |
| soft magnetic nano powder (% by volume) | | 19.8 | 19.8 | 19.8 | 21.0 | 16.7 | 16.7 | 16.7 | 3.3 | 33.0 | 19.8 | 17.8 |
| soft magnetic powde (% by volume) | | 46.2 | 46.2 | 46.2 | 42.9 | 54.6 | 54.6 | 54.6 | 62.7 | 33.0 | 46.2 | 47.4 |
| epoxy resin (% by volume) | | 29.4 | 29.4 | 29.4 | 31.2 | 24.8 | 24.8 | 24.8 | 29.4 | 29.4 | 29.4 | 30.1 |
| curing facilitator (% bv volume) | | 4.6 | 4.6 | 4.6 | 4.9 | 3.9 | 3.9 | 3.9 | 4.6 | 4.6 | 4.6 | 4.7 |
| Volume ratio B/A | | 2.33 | 2.33 | 2.33 | 2.04 | 3.27 | 3.27 | 3.27 | 19.00 | 1.00 | 2.33 | 2.67 |
| $S_A/S_B$ | | 13.8 | 18.0 | 16.4 | 11.3 | 22.5 | 30.0 | 18.0 | 13.8 | 13.8 | 4.6 | 7.7 |
| $S_A-S_B$ | | 8.4 | 8.5 | 8.5 | 8.2 | 8.6 | 8.7 | 8.5 | 8.4 | 8.4 | 2.4 | 4.4 |
| Weighted average (volume basis) | | 3.2 | 3.1 | 3.1 | 3.5 | 2.4 | 2.3 | 2.5 | 1.1 | 4.8 | 1.4 | 1.8 |
| Weighted average (mass basis) | | 3.2 | 3.1 | 3.1 | 3.3 | 3.0 | 2.9 | 3.1 | 1.1 | 4.8 | 1.4 | 2.0 |
| magnetic permeability (100MHz) | | 11.5 | 13.0 | 10.5 | 12.5 | 10.0 | 10.5 | 10.2 | 9.8 | 8.0 | 10.1 | 8.5 |
| T.I. | | 1.5 | 1.4 | 1.6 | 1.5 | 1.8 | 1.9 | 1.4 | 1.7 | 2.2 | 1.9 | 2.0 |
| filling property | | good | good | good | good | good | good | good | good | good | good | good |

Table 2

**[Table 2. Results of Comparative Examples]**

| | true specific gravity | Comparative Example | | | | |
|---|---|---|---|---|---|---|
| | | 1 | 2 | 3 | 4 | 5 |
| soft magnetic nano powder | | | | | | |
| a1 | 7.0 | | | | | |
| a2 | 7.0 | | | | | |
| a3 | 8.0 | | | | | |
| a4 | 5.0 | 30 | | 5 | 50 | |
| a5 | 5.0 | | 30 | | | |
| soft magnetic powder | | | | | | |
| b1 | 7.0 | 70 | 70 | 95 | 50 | 95 |
| b2 | 7.0 | | | | | |
| b3 | 7.0 | | | | | |
| b4 | 8.0 | | | | | |
| b5 | 5.0 | | | | | |
| b6 | 5.0 | | | | | |
| b7 | 5.0 | | | | | |
| silica | 2.2 | | | | | 5 |
| liquid epoxy resin | | | | | | |
| c1 | 1.1 | 3 | 3 | 3 | 3 | 3 |
| c2 | 1.1 | 3 | 3 | 3 | 3 | 3 |
| c3 | 1.1 | 1 | 1 | 1 | 1 | 1 |
| curing facilitator | 1.0 | 1 | 1 | 1 | 1 | 1 |
| soft magnetic nano powder (% by mass) | | 27.8 | 27.8 | 4.6 | 46.3 | 0.0 |
| soft magnetic powder (% bv mass) | | 64.8 | 64.8 | 88.0 | 46.3 | 88.0 |
| liquid epoxy resin (% bv mass) | | 6.5 | 6.5 | 6.5 | 6.5 | 6.5 |
| curing facilitator (% by mas) | | 0.9 | 0.9 | 0.9 | 0.9 | 0.9 |
| soft magnetic nano powder (% bv volume) | | 25.7 | 25.7 | 4.6 | 40.8 | 0.0 |
| soft magnetic powde (% bv volume) | | 42.8 | 42.8 | 61.9 | 29.1 | 58.5 |
| liquid epoxy resin (% by volume) | | 27.2 | 27.2 | 29.0 | 26.0 | 27.4 |
| curing facilitator (% by volume) | | 4.3 | 4.3 | 4.6 | 4.1 | 4.3 |
| Volume ratio B/A | | 1.67 | 1.67 | 13.57 | 0.71 | - |
| $S_A/S_B$ | | 17.9 | 23.1 | 16.9 | 16.9 | - |
| $S_A$-$S_B$ | | 10.4 | 14.4 | 10.4 | 10.4 | - |
| Weighted average (volume basis) | | 4.5 | 6.0 | 1.4 | 6.7 | - |
| Weighted average (mass basis) | | 3.8 | 5.0 | 1.2 | 5.8 | - |
| magnetic permeability (100MHz) | | 10.0 | 9.5 | 9.8 | 9.8 | 7.2 |

(continued)

|  | true specific gravity | Comparative Example | | | | |
|---|---|---|---|---|---|---|
|  |  | 1 | 2 | 3 | 4 | 5 |
| T.I. |  | 3.8 | 4.2 | 2.8 | 6.0 | 5.2 |
| filling property |  | poor | poor | poor | poor | poor |

Explanation of references

| 10 | core substrate |
|---|---|
| 11 | supporting substrate |
| 12 | first metal layer |
| 13 | second metal layer |
| 14 | through-hole |
| 20 | plated layer |
| 30a | resin composition |
| 30 | cured product |
| 40 | conductive layer |
| 41 | patterned conductive layer |
| 100 | circuit substrate |
| 200 | inner layer substrate |
| 200a | first main surface |
| 200b | second main surface |
| 220 | through-hole |
| 220a | in-the-through-hole wiring |
| 240 | outside terminal |
| 300 | magnetic portion |
| 310 | resin sheet |
| 320a | resin composition layer |
| 320 | first cured product layer |
| 330 | support |
| 340 | second cured product layer |
| 360 | via hole |
| 360a | in-the-via-hole wiring |
| 400 | coil-shaped conductive structural body |
| 420 | first conductive layer |
| 420a | land |
| 440 | second conductive layer |

**Claims**

1.  A resin composition comprising:

    (A) an alloy magnetic powder having a BET specific surface area $S_A$ of 2 m$^2$/g or more and 10 m$^2$/g or less;
    (B) a magnetic powder having a BET specific surface area $S_B$ of 0.1 m$^2$/g or more and less than 2 m$^2$/g; and
    (C) a binder resin.

2.  The resin composition according to claim 1, wherein a volume ratio of the (A) component and the (B) component ((B) component/(A) component) is 0.9 or more and 20.0 or less.

3.  The resin composition according to claim 1 or 2, wherein a total amount of the (A) component and the (B) component relative to 100% by volume of nonvolatile components in the resin composition is 50% or more by volume.

4. The resin composition according to any one of claims 1 to 3, wherein the (A) component comprises an iron alloy type powder comprising Fe, Si, and Cr.

5. The resin composition according to any one of claims 1 to 4, wherein the (C) component comprises a thermosetting resin.

6. The resin composition according to any one of claims 1 to 5, wherein the (C) component comprises an epoxy resin.

7. The resin composition according to claim 6, further comprising (D) an epoxy curing facilitator.

8. The resin composition according to any one of claims 1 to 7, wherein a amount of the (C) component relative to 100% by mass of resin components in the resin composition is 60% or more by mass.

9. The resin composition according to any one of claims 1 to 8, wherein the resin composition is in a pasty form at 23°C.

10. A cured product of the resin composition according to any one of claims 1 to 9.

11. A resin sheet comprising:

    a support; and
    a resin composition layer formed of the resin composition according to any one of claims 1 to 9, the resin composition layer being formed on the support.

12. A circuit substrate comprising a cured product of the resin composition according to any one of claims 1 to 9.

13. A circuit substrate comprising:

    a substrate formed with a through-hole; and
    a cured product of the resin composition according to any one of claims 1 to 9, the cured product being filled in the through-hole.

14. An inductor substrate comprising the circuit substrate according to claim 12 or 13.

# FIG.1

# FIG.2

# FIG.3

# FIG.4

# FIG.5

# FIG.6

# FIG.7

# FIG.8

# FIG.9

240  220a  220  420          200a  200b  420    240  220a  220

# FIG.10

420                    420

240  220a  220  420          200a  200b  420    240  220a  220

# FIG.11

420

420

240 220a 220 420 360    200a 200b    420 360 240 220a 220

320

200

# FIG.12

400

400

440

440 360a 420

440

420 360a 440
(420a)

240 220a 220 420 360    200a 200b    420 360 240 220a 220

320

200

# FIG.13

# FIG.14

# FIG.15

Europäisches
Patentamt

European
Patent Office

Office européen
des brevets

# EUROPEAN SEARCH REPORT

**Application Number**

EP 22 16 1891

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/343029 A1 (MIZUSHIMA TAKAO [TW]) 29 October 2020 (2020-10-29) * claims 9,11-14,16,17 * | 1-14 | INV. H01F1/28 H01F17/00 H05K1/02 |
| E | EP 3 985 691 A1 (AJINOMOTO KK [JP]) 20 April 2022 (2022-04-20) * paragraphs [0014], [0024], [0026], [0031], [0032], [0039], [0108]; claims 1,9,10,14 * | 1-14 | |
| A,D | EP 3 771 303 A1 (AJINOMOTO KK [JP]) 27 January 2021 (2021-01-27) * paragraph [0023]; claims 1-15 * | 1-14 | |

**TECHNICAL FIELDS SEARCHED (IPC)**

H01F
H05K

The present search report has been drawn up for all claims

| Place of search | Date of completion of the search | Examiner |
|---|---|---|
| Munich | 4 August 2022 | Primus, Jean-Louis |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
..............................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 16 1891

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2022

| Patent document cited in search report | | Publication date | Patent family member(s) | | Publication date |
|---|---|---|---|---|---|
| US 2020343029 | A1 | 29-10-2020 | CN | 111834075 A | 27-10-2020 |
| | | | JP | 7041099 B2 | 23-03-2022 |
| | | | JP | 2020180364 A | 05-11-2020 |
| | | | JP | 2022028777 A | 16-02-2022 |
| | | | KR | 20200124609 A | 03-11-2020 |
| | | | TW | 202039890 A | 01-11-2020 |
| | | | US | 2020343029 A1 | 29-10-2020 |
| EP 3985691 | A1 | 20-04-2022 | CN | 114350109 A | 15-04-2022 |
| | | | EP | 3985691 A1 | 20-04-2022 |
| | | | JP | 2022064864 A | 26-04-2022 |
| | | | KR | 20220049468 A | 21-04-2022 |
| EP 3771303 | A1 | 27-01-2021 | CN | 111886939 A | 03-11-2020 |
| | | | EP | 3771303 A1 | 27-01-2021 |
| | | | JP | 2022000511 A | 04-01-2022 |
| | | | JP | WO2019181463 A1 | 11-03-2021 |
| | | | KR | 20200130323 A | 18-11-2020 |
| | | | TW | 201945461 A | 01-12-2019 |
| | | | US | 2020413542 A1 | 31-12-2020 |
| | | | WO | 2019181463 A1 | 26-09-2019 |

EPO FORM P0459

For more details about this annex : see Official Journal of the European Patent Office, No. 12/82

**EP 4 060 692 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019181463 A
- JP 2015187260 A
- JP 2019220609 A
- JP 2016197624 A